# EUROPEAN PATENT APPLICATION

(11) **EP 4 435 855 A1**
(43) Date of publication of application: **25.09.2024**
(21) Application number: 23218643.7
(22) Date of filing: 20.12.2023
(51) Int. Cl.: H01L 23/538, H01L 23/367

(54) **SEMICONDUCTOR PACKAGE AND METHOD OF MANUFACTURING THE SAME**

(30) Priority: 24.03.2023 KR 20230039025; 25.04.2023 KR 20230054200
(71) Applicant: Samsung Electronics Co., Ltd., Suwon-si, Gyeonggi-do 16677 (KR)
(72) Inventor: YANG, Dongchul, 16677 Suwon-si (KR); O, Inwon, 16677 Suwon-si (KR)
(74) Representative: Marks & Clerk LLP

(57) **Abstract**

A semiconductor package includes a first redistribution substrate; a first semiconductor chip on the first redistribution substrate; a second redistribution substrate on the first semiconductor chip; inter-substrate through-electrodes on the first redistribution substrate at one side of the first semiconductor chip and connecting the first redistribution substrate to the second redistribution substrate; a second semiconductor chip on the first semiconductor chip; and a heat dissipation structure on the second semiconductor chip.

## Description

### FIELD

Embodiments relate to a semiconductor package and a method of manufacturing the semiconductor package.

### BACKGROUND

Due to the rapid development of the electronic industry and the needs of users, electronic devices are becoming more compact and lightweight. According to the miniaturization and weight reduction of the electronic devices, semiconductor packages used therein are also miniaturized and lightweight, and thus, semiconductor packages may have high reliability along with high performance and large capacity.

### SUMMARY

The embodiments may be realized by providing a semiconductor package including a first redistribution substrate; a first semiconductor chip on the first redistribution substrate; a second redistribution substrate on the first semiconductor chip; inter-substrate through-electrodes on the first redistribution substrate at one side of the first semiconductor chip and connecting the first redistribution substrate to the second redistribution substrate; a second semiconductor chip on the first semiconductor chip; and a heat dissipation structure on the second semiconductor chip. The second semiconductor chip may be indirectly on the first semiconductor chip. The second redistribution substrate may be directly on the first semiconductor chip. The second semiconductor chip may be on the second redistribution substrate. The second semiconductor chip may be directly on the second redistribution substrate. The second semiconductor chip may be directly on the first semiconductor chip.

The embodiments may be realized by providing a semiconductor package including a first redistribution substrate; a stacked chip structure on the first redistribution substrate; a second redistribution substrate on the stacked chip structure; inter-substrate through-electrodes on the first redistribution substrate on one side of the stacked chip structure and connecting the first redistribution substrate to the second redistribution substrate; and a heat dissipation structure at a portion corresponding to the stacked chip structure on the second redistribution substrate, wherein the stacked chip structure includes a first semiconductor chip, a second semiconductor chip on the first semiconductor chip, and an interposer chip on the first semiconductor chip and at one side of the second semiconductor chip. For example, the heat dissipation structure may be on the second redistribution substrate at a portion of the semiconductor package which corresponds in position to the stacked chip structure. For example, the heat dissipation structure may be on the second redistribution substrate at a portion of the semiconductor package which is positioned above the stacked chip structure.

The embodiments may be realized by providing a semiconductor package including a first redistribution substrate; a first semiconductor chip on the first redistribution substrate; a second redistribution substrate on the first semiconductor chip; inter-substrate through-electrodes on the first redistribution substrate at one side of the first semiconductor chip and connecting the first redistribution substrate to the second redistribution substrate; a second semiconductor chip on the first semiconductor chip; and a memory device on the second redistribution substrate, wherein the memory device and the second semiconductor chip are configured to exchange memory signals without the memory signals passing through the first redistribution substrate.

The embodiments may be realized by providing a method of manufacturing a semiconductor package, the method including preparing a first redistribution substrate; mounting a first semiconductor chip on the first redistribution substrate; forming inter-substrate through-electrodes on the first redistribution substrate on one side of the first semiconductor chip; sealing the inter-substrate through-electrodes and the first semiconductor chip with a sealant; forming a second redistribution substrate on the first semiconductor chip, the inter-substrate through-electrodes, and the sealant; and mounting a second semiconductor chip on the first semiconductor chip or the second redistribution substrate.

The embodiments may be realized by providing a method of manufacturing a semiconductor package, the method including preparing a first redistribution substrate; mounting a stacked chip structure on the first redistribution substrate; forming inter-substrate through-electrodes on the first redistribution substrate on one side of the stacked chip structure; sealing the inter-substrate through-electrodes and the stacked chip structure with a sealant; forming a second redistribution substrate on the stacked chip structure, and the inter-substrate through-electrodes, and the sealant; and stacking a memory device and a heat dissipation structure on the second redistribution substrate, wherein mounting the stacked chip structure includes mounting a second semiconductor chip on a first semiconductor chip; mounting an interposer chip on the first semiconductor chip on one side of the second semiconductor chip; and mounting the first semiconductor chip on the first redistribution substrate.

At least some of the above and other features of the invention are set out in the claims.

### BRIEF DESCRIPTION OF THE DRAWINGS

Features will be apparent to those of skill in the art by describing in detail embodiments with reference to the attached drawings in which:
FIG. 1 is a cross-sectional view of a semiconductor package according to an embodiment;
FIG. 2 is a cross-sectional view showing a first semiconductor chip in the semiconductor package of FIG. 1;
FIGS. 3A and 3B are cross-sectional views respectively showing transmission paths of memory signals in a semiconductor package according to a comparative example and a semiconductor package according to an embodiment respectively;
FIGS. 4A to 4C are cross-sectional views showing the structure of a memory device in the semiconductor package of FIG. 1;
FIGS. 5 to 7 are cross-sectional views of semiconductor packages according to embodiments;
FIG. 8A is a cross-sectional view of a semiconductor package according to an embodiment;
FIG. 8B is a cross-sectional view showing an interposer chip in the semiconductor package of FIG. 8A according to an embodiment;
FIG. 9 is a cross-sectional view of a semiconductor package according to an embodiment;
FIGS. 10A to 10G are schematic cross-sectional views of stages in a method of manufacturing the semiconductor package of FIG. 1 according to an embodiment;
FIGS. 11A to 11D are schematic cross-sectional views of stages in a method of manufacturing the semiconductor package of FIG. 5 according to an embodiment;
FIGS. 12A to 12E are schematic cross-sectional views of stages in a method of manufacturing the semiconductor package of FIG. 6 according to an embodiment;
FIGS. 13A to 13C are schematic cross-sectional views of stages in a method of manufacturing the semiconductor package of FIG. 7 according to an embodiment;
FIGS. 14A to 14E are schematic cross-sectional views of stages in a method of manufacturing the semiconductor package of FIG. 8A according to an embodiment; and
FIGS. 15A to 15C are schematic cross-sectional views of stages in a method of manufacturing the semiconductor package of FIG. 9 according to an embodiment.

### DETAILED DESCRIPTION

Hereinafter, embodiments will be described in detail with reference to the accompanying drawings.

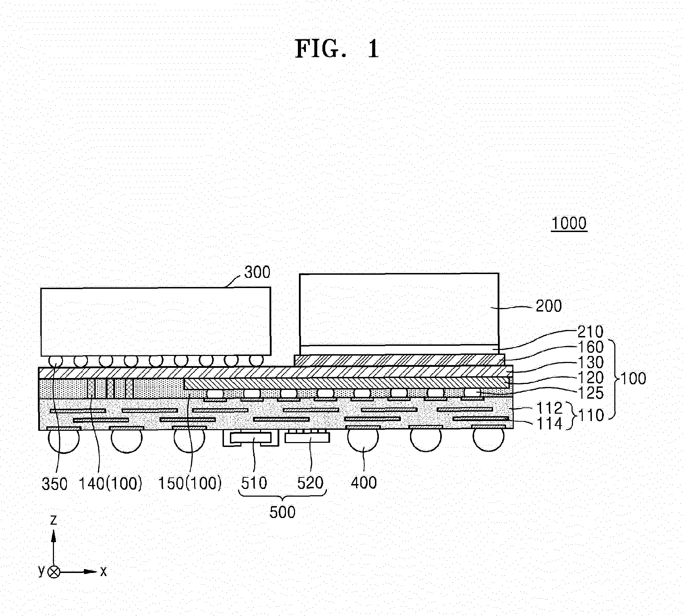

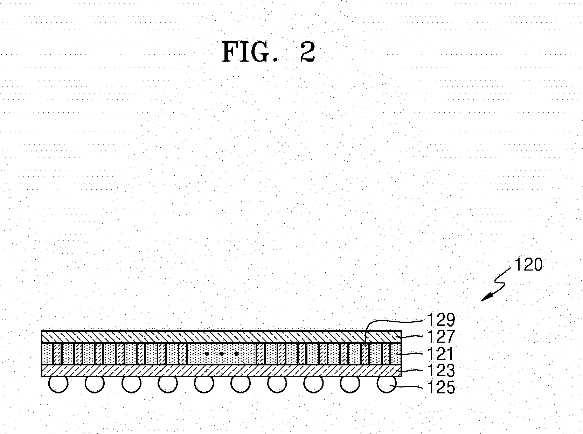

Like reference numerals are used for the like elements in the drawings, and repeated descriptions thereof may be omitted. FIG. 1 is a cross-sectional view of a semiconductor package 1000 according to an embodiment. FIG. 2 is a cross-sectional view of a first semiconductor chip in more detail in the semiconductor package 1000 of FIG. 1. Referring to FIGS. 1 and 2, the semiconductor package 1000 according to an embodiment may include a lower package 100, a heat dissipation structure 200, a memory device 300, external connection terminals 400, and a passive device 500.

The lower package 100 may include a first redistribution substrate 110, a first semiconductor chip 120, a second redistribution substrate 130, inter-substrate through-electrodes 140, a sealant 150, and a second semiconductor chip 160. The first redistribution substrate 110 may be under the first semiconductor chip 120 and may redistribute chip pads of the first semiconductor chip 120 to an external region of the first semiconductor chip 120.

In an implementation, the first redistribution substrate 110 may include a first body insulating layer 112 and a first redistribution line 114. The first redistribution line 114 may be formed in multiple layers and connected to each other by vias. The first body insulating layer 112 may include an insulating material, e.g., a photo imageable dielectric (PID) resin, and may further include an inorganic filler.

In an implementation, the first body insulating layer 112 may have a multi-layer structure according to the multi-layer structure of the first redistribution line 114. In an implementation, as illustrated in FIG. 1, the first body insulating layer 112 may be a single layer structure. In an implementation, the first body insulating layer 112 may have a multilayer structure, and different layers of the first body insulating layer 112 may include the same material or different materials from each other. The external connection terminals 400 may be on a lower surface of the first body insulating layer 112.

The external connection terminals 400 may be on an external connection pad on the lower surface of the first body insulating layer 112. The external connection terminals 400 may be electrically connected to the first semiconductor chip 120 through the first redistribution line 114 of the first redistribution substrate 110 and bumps 125. The external connection terminals 400 may be on a first lower surface of the first redistribution substrate 110 corresponding to a lower surface of the first semiconductor chip 120 and a second lower surface of the first redistribution substrate 110 extending outwardly from the first lower surface in an x direction. For example, the external connection terminals 400 may be on the first lower surface of the first redistribution substrate 110 in a first region of the first lower surface of the first redistribution substrate 110 which corresponds in x and y directions with a lower surface of the first semiconductor chip 120 and the external connection terminals 400 may be on the first lower surface of the first redistribution substrate 110 in a second region of the lower surface of the first redistribution substrate 110, wherein the second region of the lower surface of the first redistribution substrate 110 extends outwardly in the x direction from the first region of the lower surface of the first redistribution substrate 110.

In an implementation, a package structure in which the external connection terminals 400 are disposed on the first lower surface of the first redistribution substrate 110 in a wider area than the lower surface of the first semiconductor chip 120 may be referred to as a fan-out (FO) package structure. In an implementation, a package structure in which the external connection terminals 400 are only on a portion of the first lower surface of the first redistribution substrate 110 corresponding to the lower surface of the first semiconductor chip 120 (e.g. in which the external connection terminals 400 are only on a portion of the first lower surface of the first redistribution substrate 110 corresponding to the lower surface of the first semiconductor chip 120 in the x and y directions) may be referred to as a fan-in (FI) package structure. The first semiconductor chip 120 may be mounted on the first redistribution substrate 110 through the bumps 125.

The bumps 125 may include, e.g., pillars and solder. In an implementation, the bumps 125 may include only solder. The first semiconductor chip 120 may be on the first redistribution substrate 110 offset from a centre of the first redistribution substrate 110 (in the x direction). In an implementation, as shown in FIG. 1, the first semiconductor chip 120 may be displaced or biased to the right in the x direction on the first redistribution substrate 110. In an implementation, the first semiconductor chip 120 may be biased to the right in the x direction, and the second semiconductor chip 160 and the heat dissipation structure 200 thereon may also be biased to the right in the x direction. This arrangement structure may be a method to help effectively dissipate heat generated from the first semiconductor chip 120 and the second semiconductor chip 160. The first semiconductor chip 120 may be an analog chip.

In an implementation, the first semiconductor chip 120 may be a modem chip supporting communication of the second semiconductor chip 160. In an implementation, the first semiconductor chip 120 may include various types of integrated devices supporting the operation of the second semiconductor chip 160. The first semiconductor chip 120 may include a multi-channel I/O interface for exchanging memory signals with the memory device 300. In an implementation, as shown in FIG. 2, the first semiconductor chip 120 may include a substrate 121, a device layer 123, a rear wiring layer 127, and through-electrodes 129.

The substrate 121 may constitute a body of the first semiconductor chip 120 and may be based on a silicon substrate. The device layer 123 may be on a lower portion of the substrate 121. In an implementation, the device layer 123 may include an integrated circuit layer in which active devices such as transistors are disposed, and a multi-wiring layer connected to the integrated circuit layer. In an implementation, the multi-wiring layer may occupy most of the device layer 123, and the integrated circuit layer may occupy only a part of the device layer 123. In an implementation, as illustrated in FIG. 2, most of the device layer 123 may be a multi-wiring layer, and an integrated circuit layer may be on an upper portion of a central portion of the device layer 123. In an implementation, as the term implies, the multi-wiring layer may include wires of multiple layers, and wires of different layers may be connected to each other through vias. Chip pads connected by wires may be on a lower surface of the device layer 123, and the bumps 125 may be on the chip pads. The rear wiring layer 127 may be on the substrate 121.

Wires may be in the rear wiring layer 127, and the wires may be in a single layer or multiple layers. In the case of multi-layer wirings, wirings of different layers may be connected to each other through vias. Upper pads connected to wires may be on an upper surface of the rear wiring layer 127. Redistribution lines of the second redistribution substrate 130 may be connected to upper pads of the rear wiring layer 127. The through-electrodes 129 may pass through the substrate 121 to connect wires of the rear wiring layer 127 and wires of the device layer 123 to each other.

In an implementation, the through-electrodes 129 may penetrate through silicon constituting the substrate 121, and the through-electrodes 129 may be referred to as a through silicon via (TSV). In an implementation, the through-electrodes 129 may include a via-first structure formed before the formation of the integrated circuit layer of the device layer 123, a via-middle structure formed after the formation of the integrated circuit layer and before the formation of the multi-wiring layer of the device layer 123, and a via-last structure formed after the formation of the multi-wiring layer. In an implementation, in FIG. 1, the through-electrodes 129 may correspond to, e.g., the via-middle structure. In the semiconductor package 1000 according to an embodiment, the through-electrodes 129 may be formed in a via-first structure or a via-last structure. In the first semiconductor chip 120, the lower surface may be a front surface, which is an active surface, and an upper surface may be a back surface, which is an inactive surface.

In an implementation, the lower surface of the device layer 123 may correspond to the front surface of the first semiconductor chip 120, and the upper surface of the rear wiring layer 127 may correspond to the rear surface of the first semiconductor chip 120. The chip pads may be on the front surface, which is an active surface, and the first semiconductor chip 120 may be mounted on the first redistribution substrate 110 in a flip-chip structure through the bumps 125 on the chip pads. The second redistribution substrate 130 may be on the first semiconductor chip 120, the inter-substrate through-electrodes 140, and the sealant 150.

The second redistribution substrate 130 may have a structure similar to that of the first redistribution substrate 110 and may have a thickness different from that of the first redistribution substrate 110. In an implementation, the second redistribution substrate 130 may include a body insulation layer and redistribution lines, and the number of layers of the redistribution lines may be less than the number of layers of the first redistribution lines 114 of the first redistribution substrate 110. In an implementation, the number of layers of the redistribution lines of the second redistribution substrate 130 may be substantially the same as the number of layers of the first redistribution lines 114 of the first redistribution substrate 110. In an implementation, the redistribution lines of the second redistribution substrate 130 may be electrically connected to the external connection terminals 400 through the inter-substrate through-electrodes 140 and the first redistribution line 114 of the first redistribution substrate 110. The inter-substrate through-electrodes 140 may be between the first redistribution substrate 110 and the second redistribution substrate 130.

In an implementation, the sealant 150 may be between the first redistribution substrate 110 and the second redistribution substrate 130, and the inter-substrate through-electrodes 140 may have a structure extending through the sealant 150. The inter-substrate through-electrodes 140 may electrically connect the first redistribution substrate 110 and the second redistribution substrate 130. In an implementation, the inter-substrate through-electrodes 140 may be connected to the first redistribution line 114 of the first redistribution substrate 110 and may also be connected to a redistribution line of the second redistribution substrate 130. The inter-substrate through-electrodes 140 may include, e.g., Cu.

In an implementation, the inter-substrate through-electrodes 140 may be formed through electroplating using a seed metal. The inter-substrate through-electrodes 140 may be referred to as a Cu-post or a through post. The seed metal may include, e.g., Cu, titanium (Ti), tantalum (Ta), titanium nitride (TiN), or tantalum nitride (TaN). In the semiconductor package 1000 according to an embodiment, the seed metal may be included as a portion of the inter-substrate through-electrodes 140. In an implementation, the seed metal may include Cu, and the inter-substrate through-electrodes 140 may also include Cu. In FIG. 1, the seed metal is not separately shown. The sealant 150 may be between the first redistribution substrate 110 and the second redistribution substrate 130. As used herein, the term "or" is not necessarily an exclusive term, e.g., "A or B" would include A, B, or A and B.

The sealant 150 may cover and seal a side surface of the first semiconductor chip 120. In addition, the sealant 150 may cover side surfaces of the inter-substrate through-electrodes 140. In an implementation, as shown in FIG. 1, the sealant 150 may fill between the first redistribution substrate 110 and the first semiconductor chip 120 and between the bumps 125 on the lower surface of the first semiconductor chip 120. In an implementation, an underfill may be filled between the bumps 125 on the lower surface of the first semiconductor chip 120, and the sealant 150 may cover side surfaces of the first semiconductor chip 120 and the underfill. The sealant 150 may include an insulating material, e.g., a thermosetting resin such as epoxy resin, a thermoplastic resin such as polyimide, or a resin including a reinforcing material such as an inorganic filler.

In an implementation, the sealant 150 may include ABF, FR-4, or BT resin. In an implementation, the sealant 150 may include a molding material such as EMC or a photosensitive material such as photo imageable encapsulant (PIE). The second semiconductor chip 160 may be mounted on the second redistribution substrate 130.

In an implementation, the second semiconductor chip 160 may be on the second redistribution substrate 130 offset from a centre of the second redistribution substrate 130 in the x direction, e.g., corresponding to the location of the first semiconductor chip 120. In an implementation, the second semiconductor chip 160 may be above the first semiconductor chip 120, and a signal path length between the first semiconductor chip 120 and the second semiconductor chip 160 may be minimized. The second semiconductor chip 160 may be mounted on the second redistribution substrate 130 through, e.g., fine bumps. In an implementation, the second semiconductor chip 160 may be mounted on the second redistribution substrate 130 through a pad-to-pad bonding, a hybrid bonding (HB), or a bonding using an anisotropic conductive film (ACF).

In an implementation, the pads may include Cu, and the pad-to-pad bonding is also referred to as Cu-to-Cu bonding. HB may denote a combination of a pad-to-pad bonding and an insulator-to-insulator bonding. ACF is an anisotropic conductive film formed to conduct electricity in only one direction, and may denote a conductive film formed into a film state by mixing fine conductive particles with an adhesive resin. In the semiconductor package 1000 according to an embodiment, the second semiconductor chip 160 may be mounted by using the HB on the second redistribution substrate 130, a substrate pad of the second redistribution substrate 130 may be coupled to a pad of the second semiconductor chip 160, and a body insulating layer of the second redistribution substrate 130 may be coupled to an insulating layer of the second semiconductor chip 160. The second semiconductor chip 160 may include a plurality of logic elements therein.

Here, the logic element may refer to an element that performs various signal processing by including, e.g., logic circuits such as AND, OR, NOT, flip-flop, or the like. In the semiconductor package 1000 according to an embodiment, the second semiconductor chip 160 may be, e.g., an application processor (AP) chip. The second semiconductor chip 160 may also be referred to as a control chip, a process chip, a CPU chip, or the like depending on its function. The second semiconductor chip 160 may include a substrate and a device layer, and unlike the first semiconductor chip 120, may not include a rear wiring layer and through-electrodes.

The device layer may include an integrated circuit layer and a multi-wiring layer. The integrated circuit layer may include multiple integrated elements. The multi-wiring layer may be under the integrated circuit layer and may include multi-layered wires. In the second semiconductor chip 160, a lower surface may be a front surface, which is an active surface, and an upper surface may be a rear surface, which is an inactive surface. In an implementation, the lower surface of the device layer may correspond to the front surface of the second semiconductor chip 160 and the upper surface of the substrate may correspond to the rear surface of the second semiconductor chip 160. The heat dissipation structure 200 may be stacked on the second semiconductor chip 160 through an adhesive layer 210.

The heat dissipation structure 200 may include, e.g., a heatsink or a heatslug. The adhesive layer 210 may include a material having high thermal conductivity. In an implementation, the adhesive layer 210 may include a thermal interface material (TIM) or thermally conductive resin. The TIM may include a material having high thermal conductivity, e.g., low thermal resistance, such as grease, a tape, an elastomer filling pad, or a phase change material. The memory device 300 may be mounted on the second redistribution substrate 130 adjacent to the second semiconductor chip 160.

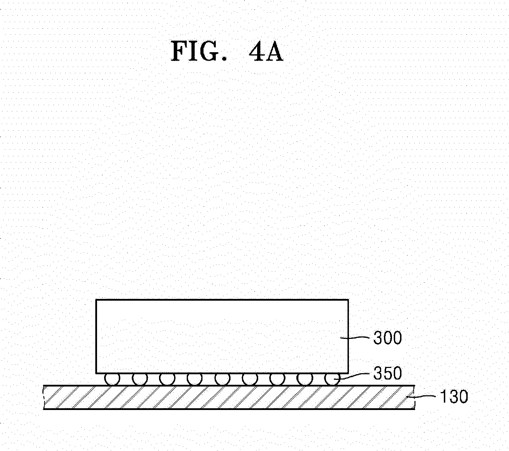

The memory device 300 may be a single chip or a package including a plurality of chips. In an implementation, the memory device 300 may be a package, and the semiconductor package 1000 according to an embodiment may correspond to a package on package (POP) structure. In an implementation, the semiconductor package 1000 may have a structure in which the memory device 300, which is an upper package, is stacked on the lower package 100. The memory device 300 may be mounted on the second redistribution substrate 130 in a flip-chip bonding structure or a wire bonding structure. Various structures and bonding structures of the memory device 300 will be described in more detail in the description of FIGS. 4A to 4C. The external connection terminals 400 may be on an external connection pad on the lower surface of the first redistribution substrate 110 and electrically connected to the first redistribution line 114 through the external connection pad.

The external connection terminals 400 may connect the semiconductor package 1000 to a package substrate of an external system or a main board of an electronic device such as a mobile device. The external connection terminals 400 may include a conductive material, e.g., solder, tin (Sn), silver (Ag), copper (Cu), or aluminum (Al). The passive device 500 may be on the lower surface of the first redistribution substrate 110.

In an implementation, the passive device 500 may be on or inside the first redistribution substrate 110. In an implementation, the passive device 500 may be on the lower surface, upper surface, or inside of the second redistribution substrate 130. The passive device 500 may include a two-terminal element such as a resistor, an inductor, or a capacitor. In the semiconductor package 1000 according to an embodiment, the passive device 500 may include a multi-layer ceramic capacitor (MLCC) 510 and a Si-capacitor 520. In the semiconductor package 1000 according to an embodiment, only the first semiconductor chip 120 may be between the first redistribution substrate 110 and the second redistribution substrate 130.

In an implementation, a distance between the first redistribution substrate 110 and the second redistribution substrate 130 may be reduced, thereby reducing the size and pitch of the inter-substrate through-electrodes 140. As a result, the thickness and size of the entire semiconductor package 1000 may be reduced. In addition, in the semiconductor package 1000 according to an embodiment, the heat dissipation structure 200 may be directly stacked on the second semiconductor chip 160, and the upper surface of the first semiconductor chip 120 may directly contact the lower surface of the second redistribution substrate 130.

Accordingly, heat generated from the first semiconductor chip 120 and the second semiconductor chip 160 may be effectively dissipated through the second redistribution substrate 130 and the heat dissipation structure 200. Furthermore, in the semiconductor package 1000 according to an embodiment, a signal transmission path length for exchanging memory signals between the memory device 300 and the second semiconductor chip 160 may be minimized.

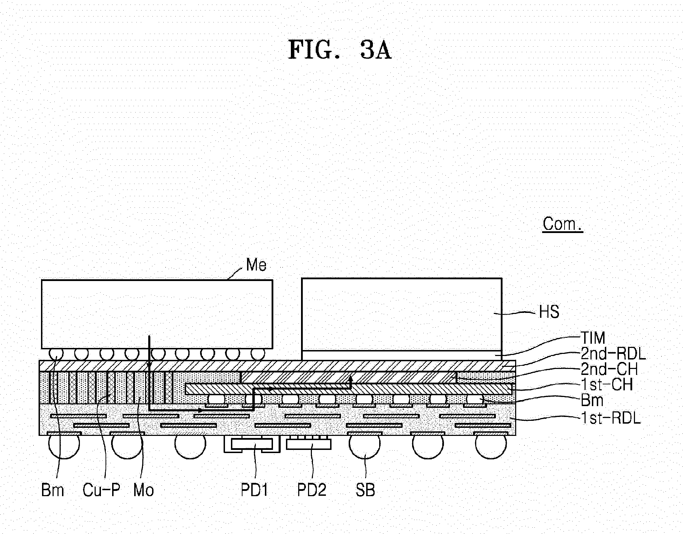

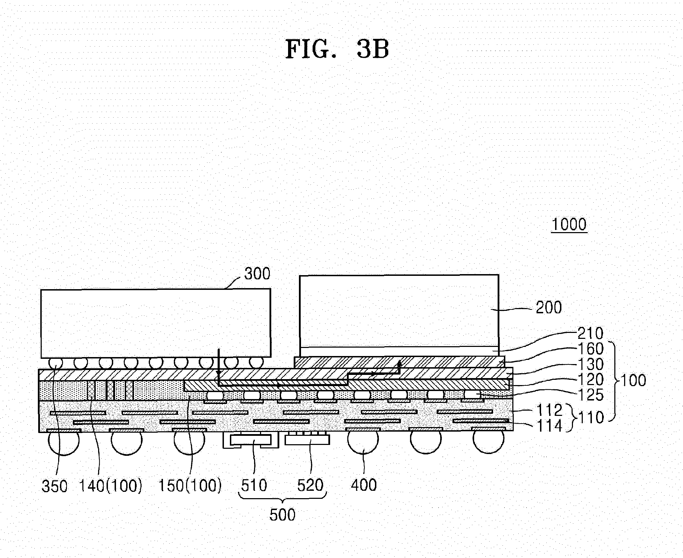

In an implementation, a memory signal between the memory device 300 and the second semiconductor chip 160 may be transmitted through the second redistribution substrate 130 and the semiconductor chip 120 without the memory signal passing through the inter-substrate through-electrodes 140 and the first redistribution substrate 110. As a result, the operating performance of the semiconductor package 1000 according to an embodiment may be greatly improved at a system level. In an implementation, the operating performance may include, e.g., heat reduction, signal integrity (SI) improvement, power ratio (performance/power consumption) improvement, or the like. The signal transfer path between the memory device 300 and the second semiconductor chip 160 in the semiconductor package 1000 according to an embodiment will be described in more detail in the description of FIGS. 3A and 3B. FIGS. 3A and 3B are cross-sectional views illustrating transmission paths of memory signals in a semiconductor package Com. according to a comparative example and the semiconductor package 1000 of FIG. 1.

Referring to FIGS. 3A and 3B, the semiconductor package Com. according to the comparative example may have a structure in which a second semiconductor chip 2nd-CH is stacked on a first semiconductor chip 1st-CH, and the first semiconductor chip 1st-CH may be mounted on the first redistribution substrate 1 st-RDL.

The first semiconductor chip 1st-CH and the second semiconductor chip 2nd-CH may be sealed with a sealant Mo, and the second redistribution substrate 2nd-RDL may cover the sealant Mo and the second semiconductor chip 2nd-CH. A through post Cu-P may penetrate the sealant Mo to connect the first redistribution substrate 1st-RDL to the second redistribution substrate 2nd-RDL. The heat slug HS may be stacked on the second redistribution substrate 2nd-RDL corresponding to the position of the second semiconductor chip 2nd-CH, and a memory element Me may be mounted on the second redistribution substrate 2nd-RDL adjacent to one side of the heat slug HS. In the semiconductor package Com. according to the comparative example having such a structure described above, the transmission of a memory signal between the memory element Me and the second semiconductor chip 2nd-CH may be, as indicated by an arrow, achieved through the second redistribution substrate 2nd-RDL, the through post Cu-P, the first redistribution substrate 1st-RDL, and a first semiconductor chip 1st-CH. Here, the memory signal may refer to a signal related to storing information in the memory element Me and reading information from the memory element Me. In FIG. 3A, PD1 and PD2 may denote passive elements, SB denotes a solder ball, Mo denotes a sealing material, and Bm denotes a bump. In contrast, in the semiconductor package 1000 according to an embodiment, only the first semiconductor chip 120 may be between the first redistribution substrate 110 and the second redistribution substrate 130, and the second semiconductor chip 160 may be disposed on the second redistribution substrate 130.

In addition, in the semiconductor package 1000 according to an embodiment, the transmission of a memory signal between the memory device 300 and the second semiconductor chip 160, as indicated by an arrow, may be performed through the second redistribution substrate 130 and the first semiconductor chip 120, and may not pass through the inter-substrate through-electrodes 140 and the first redistribution substrate 110. In an implementation, the signal transmission path may be described in more detail with the structure of the first semiconductor chip 120 of FIG. 2, and the memory device 300 and the second semiconductor chip 160 may exchange a memory signal through the second redistribution substrate 130, the rear wiring layer 127, the through-electrodes 129, the device layer 123, the through-electrodes 129, the rear wiring layer 127, and the second redistribution substrate 130. Therefore, in the semiconductor package 1000 according to an embodiment, the inter-substrate through-electrodes 140 and the first redistribution substrate 110 may not be used for the transmission of a memory signal, and the length of the signal transmission path of the memory signal may be minimized. In addition, the inter-substrate through-electrodes 140 may be used only for power and ground transmission, and the number of inter-substrate through-electrodes 140 may be greatly reduced. Furthermore, a distance between the first redistribution substrate 110 and the second redistribution substrate 130 may be reduced, and a length of the inter-substrate through-electrodes 140 may also be reduced. As a result, the size and pitch of the inter-substrate through-electrodes 140 may be greatly reduced, and the size and thickness of the entire semiconductor package 1000 may be reduced. In an implementation, in the semiconductor package 1000 according to an embodiment, power and ground may be applied to the memory device 300 from the outside through the first redistribution substrate 110, the inter-substrate through-electrodes 140, and the second redistribution substrate 130. FIGS. 4A to 4C are cross-sectional views showing a structure of the memory device 300 in the semiconductor package 1000 of FIG. 1 in more detail.

Referring to FIG. 4A, the memory device 300 may include a volatile memory device such as dynamic random access memory (DRAM) and static random access memory (SRAM), or a non-volatile memory device such as flash memory.

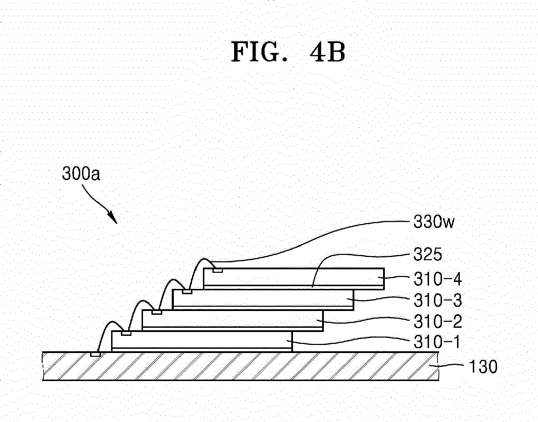

In the semiconductor package 1000 according to an embodiment, the memory device 300 may be, e.g., a DRAM device. The memory device 300 may be mounted on the second redistribution substrate 130 with a flip-chip bonding structure using bumps 350. The memory device 300 may have a single memory chip structure or a package structure in which a plurality of memory chips is included. Referring to FIG. 4B, a memory device 300a may include a plurality of stacked memory chips 310-1 to 310-4 and may be mounted on the second redistribution substrate 130 with a wire bonding structure using an adhesive layer 325 and a wire 330w.

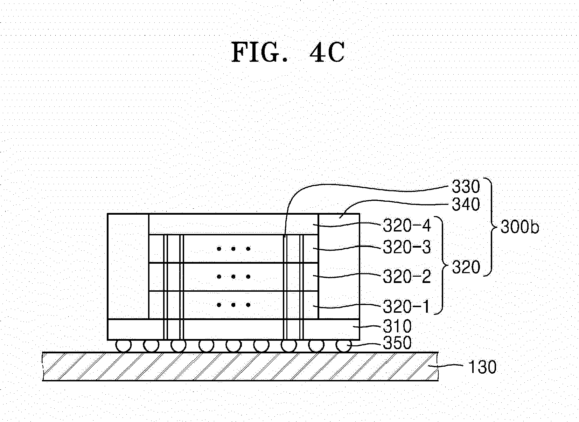

In an implementation, as illustrated in FIG. 4B, four memory chips 310-1 to 310-4 may be stacked. In an implementation, three or less memory chips, or five or more memory chips may be stacked. In an implementation, the memory chips may be stacked in a zigzag structure or a combination structure of a stair structure and a zigzag structure. Referring to FIG. 4C, a memory device 300b may be a high bandwidth memory (HBM) package.

In an implementation, the memory device 300b may include a base chip 310 and a plurality of core chips 320 on the base chip 310. In an implementation, the base chip 310 and the core chips 320 may include through-electrodes 330 therein. In an implementation, the uppermost core chip among the core chips 320 may not include the through-electrodes 330. The base chip 310 may include logic elements.

In an implementation, the base chip 310 may be a logic chip. The base chip 310 may be under the core chips 320, integrate signals of the core chips 320 to transmit the signals to the outside, and transmit external signals and power to the core chips 320. In an implementation, the base chip 310 may be referred to as a buffer chip or a control chip. Each of the core chips 320 may be a plurality of memory chips. In an implementation, each of the core chips 320 may be a DRAM chip. The core chips 320 may be stacked on the base chip 310 or the lower core chip 320 through a pad-to-pad bonding, a hybrid bonding, a bonding using a bonding member, or a bonding using an ACF. In an implementation, as illustrated in FIG. 4C, four core chips 320 may be stacked. In an implementation, three or less core chips, or five or more core chips may be stacked. Bumps 350 may be on a lower surface of the base chip 310.

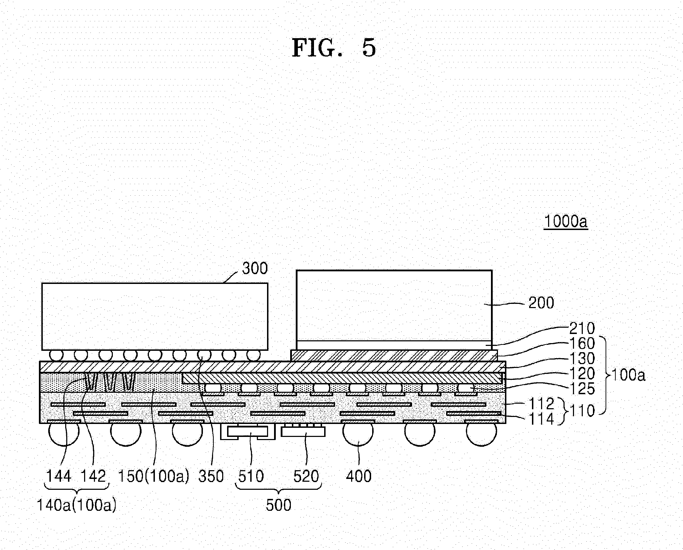

The bumps 350 may be connected to the through-electrodes 330. The bumps 350 may include a pillar and solder or only a solder. The memory device 300b may be mounted on the second redistribution substrate 130 through the bumps 350. The core chips 320 on the base chip 310 may be sealed by an inner sealant 340. In an implementation, the uppermost core chip 320-4 among the core chips 320 may not be covered by the inner sealant 340. In an implementation, an upper surface of the uppermost core chip 320-4 may be covered by the inner sealant 340. FIGS. 5 to 7 are cross-sectional views of semiconductor packages according to embodiments.

Descriptions already given with reference to FIGS. 1 to 4C may be only briefly described or omitted. Referring to FIG. 5, a semiconductor package 1000a according to an embodiment may be different from the semiconductor package 1000 of FIG. 1 in the structure of a lower package 100a.

The semiconductor package 1000a according to an embodiment may include the lower package 100a, a heat dissipation structure 200, a memory device 300, external connection terminals 400, and a passive device 500. The heat dissipation structure 200, the memory device 300, the external connection terminals 400, and the passive device 500 may be the same as the descriptions given with reference to the semiconductor package 1000 of FIG. 1. The lower package 100a may include a first redistribution substrate 110, a first semiconductor chip 120, a second redistribution substrate 130, inter-substrate through-electrodes 140a, a sealant 150, and a second semiconductor chip 160.

The first redistribution substrate 110, the first semiconductor chip 120, the second redistribution substrate 130, the sealant 150, and the second semiconductor chip 160 may be the same as the descriptions given with reference to the lower package 100 of the semiconductor package 1000 of FIG. 1. In the semiconductor package 1000 according to an embodiment, the inter-substrate through-electrode 140a may include an electrode metal layer 142 and a barrier metal layer 144.

In an implementation, the electrode metal layer 142 may include, e.g., Cu, W, Al, or the like. In an implementation, the barrier metal layer 144 may include, e.g., Ti/TiN. The inter-substrate through-electrodes 140a may be formed through a laser drilling and a deposition process.

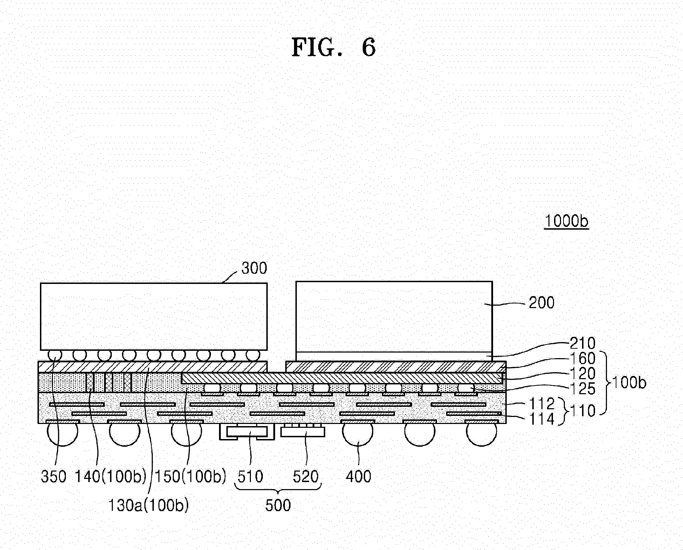

In an implementation, the inter-substrate through-electrodes 140a may be formed by forming trenches in the sealant 150 through a laser drilling process and filling the trench with a metal material through a deposition process. In an implementation, due to the method of forming the inter-substrate through-electrodes 140a, the size and pitch of the inter-substrate through-electrodes 140a may be greater than those of the inter-substrate through-electrodes 140 of the semiconductor package 1000 of FIG. 1. In an implementation, the inter-substrate through-electrodes 140a may have substantially the same size and pitch as the inter-substrate through-electrodes 140 of the semiconductor package 1000 of FIG. 1. Referring to FIG. 6, a semiconductor package 1000b according to an embodiment may be different from the semiconductor package 1000 of FIG. 1 in the structure of a lower package 100b.

In the semiconductor package 1000b according to an embodiment, the lower package 100b may include a first redistribution substrate 110, a first semiconductor chip 120, a second redistribution substrate 130a, inter-substrate through-electrodes 140, a sealant 150, and a second semiconductor chip 160. The first redistribution substrate 110, the inter-substrate through-electrodes 140, and the sealant 150 may be the same as the descriptions given with reference to the lower package 100 of the semiconductor package 1000 of FIG. 1. In the semiconductor package 1000b according to an embodiment, the second semiconductor chip 160 may be directly stacked on the first semiconductor chip 120.

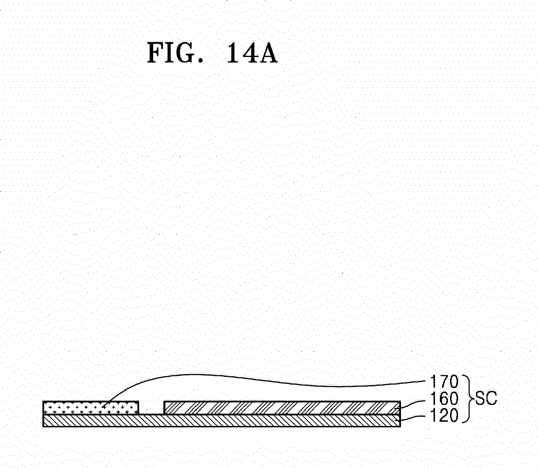

The first semiconductor chip 120 and the second semiconductor chip 160 may form a stacked chip structure (refer to SC in FIG. 14A). With the stacked chip structure SC, the first semiconductor chip 120 and the second semiconductor chip 160 may be mounted together on the first redistribution substrate 110. In the stacked chip structure, the second semiconductor chip 160 may be stacked on the first semiconductor chip 120 through a bonding using fine bumps, a bonding using ACF, HB, or the like. In the semiconductor package 1000b according to an embodiment, the second redistribution substrate 130a may cover the inter-substrate through-electrodes 140 and the sealant 150 and may cover only a portion of the upper surface of the first semiconductor chip 120.

In an implementation, on the upper surface of the first semiconductor chip 120, the second redistribution substrate 130a and the second semiconductor chip 160 may be (e.g., laterally) adjacent to each other with a predetermined gap therebetween. The heat dissipation structure 200 may be stacked on the second semiconductor chip 160 and attached thereto through the adhesive layer 210. In the semiconductor package 1000b according to an embodiment, the transmission of a memory signal between the memory device 300 and the second semiconductor chip 160 may not pass through the inter-substrate through-electrodes 140 and the first redistribution substrate 110.

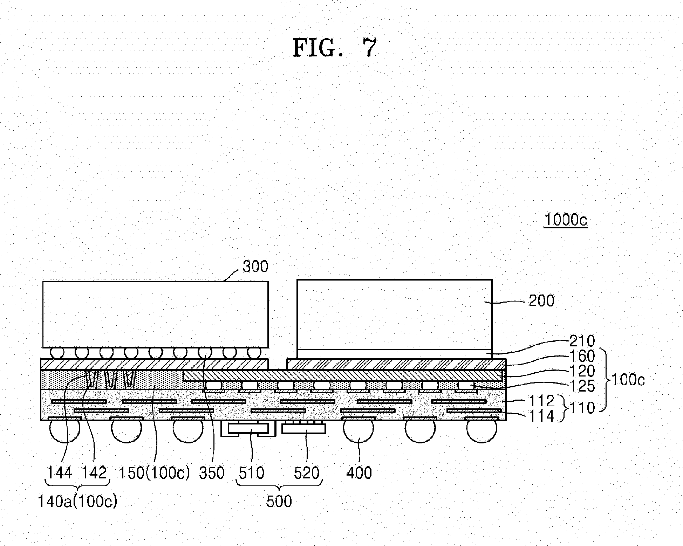

In the semiconductor package 1000b according to an embodiment, the memory device 300 and the second semiconductor chip 160 may exchange memory signals through the second redistribution substrate 130a, the rear wiring layer 127, the through-electrodes 129, the device layer 123, the through-electrodes 129, and the rear wiring layer 127. The second redistribution substrate 130a may not be between the first semiconductor chip 120 and the second semiconductor chip 160, the signal transmission path may be shortened, and the heat dissipation performance of the first semiconductor chip 120 and the second semiconductor chip 160 may further be improved. Referring to FIG. 7, a semiconductor package 1000c according to an embodiment may be substantially the same as the semiconductor package 1000b of FIG. 6 except that a lower package 100c may include inter-substrate through-electrodes 140a.

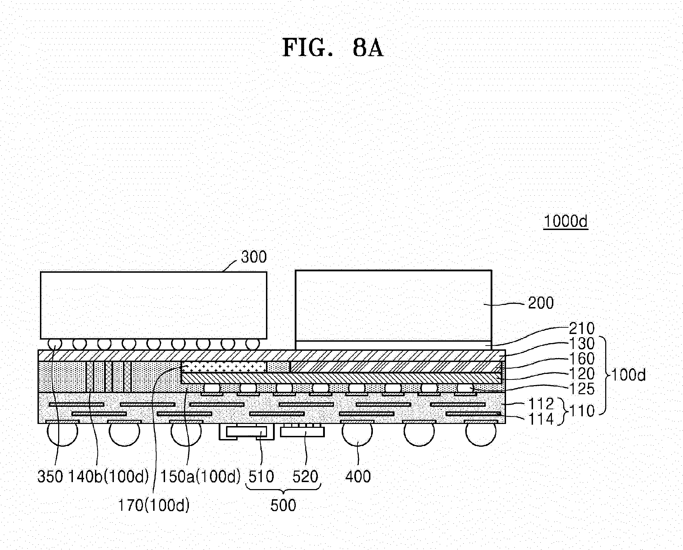

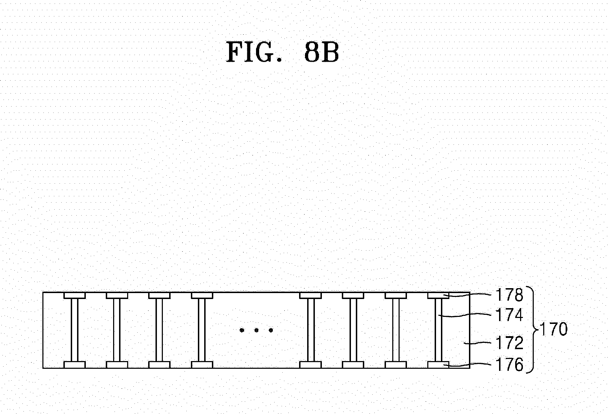

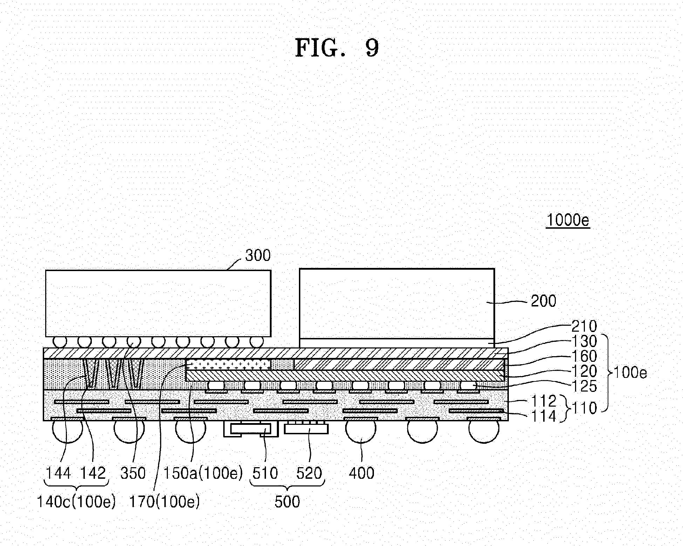

The inter-substrate through-electrode 140a may include an electrode metal layer 142 and a barrier metal layer 144. The inter-substrate through-electrodes 140a may be the same as the description given with reference to the semiconductor package 1000a of FIG. 5. FIGS. 8A and 9 are cross-sectional views of semiconductor packages 1000d and 1000e according to embodiments, and FIG. 8B is a cross-sectional view showing an interposer chip in more detail in the semiconductor package 1000d of FIG. 8A.

Descriptions already given with reference to FIGS. 1 to 7 may be only briefly described or omitted. Referring to FIGS. 8A and 8B, the semiconductor package 1000d according to an embodiment may be significantly different from the semiconductor package 1000 of FIG. 1 in the structure of a lower package 100d.

The semiconductor package 1000d according to an embodiment may include a lower package 100d, a heat dissipation structure 200, a memory device 300, external connection terminals 400, and a passive device 500. Except that the heat dissipation structure 200 is stacked on the second redistribution substrate 130, the heat dissipation structure 200, the memory device 300, the external connection terminals 400, and the passive device 500 may be the same as the descriptions given with reference to the semiconductor package 1000 of FIG. 1. The lower package 100d may include a first redistribution substrate 110, a first semiconductor chip 120, a second redistribution substrate 130, inter-substrate through-electrodes 140b, a sealant 150a, a second semiconductor chip 160, and an interposer chip 170.

In an implementation, the first semiconductor chip 120, the second semiconductor chip 160, and the interposer chip 170 may constitute a stacked chip structure (refer to SC in FIG. 14A), and the stacked chip structure SC may be between the first redistribution substrate 110 and the second redistribution substrate 130. The stacked chip structure SC may be between the first redistribution substrate 110 and the second redistribution substrate 130, a distance between the first redistribution substrate 110 and the second redistribution substrate 130 may increase, and, as a result, the size and pitch of the inter-substrate through-electrodes 140b may increase. In an implementation, the thickness of the sealant 150a may also increase. The interposer chip 170 may be stacked on an upper surface of the first semiconductor chip 120 as shown in FIG. 8A.

In an implementation, the interposer chip 170 may be (e.g., laterally) adjacent to the second semiconductor chip 160 at a predetermined interval or distance therebetween. The interposer chip 170 may be, e.g., a silicon interposer chip. In an implementation, as shown in FIG. 8B, the interposer chip 170 may include a silicon substrate 172, through-electrodes 174, lower pads 176, and upper pads 178. The through-electrode 174 may directly connect the lower pad 176 and the upper pad 178. In the semiconductor package 1000d according to the present embodiment, the interposer chip 170 may be included, and the transmission of a memory signal between the memory device 300 and the second semiconductor chip 160 may not pass through the inter-substrate through-electrodes 140b and the first redistribution substrate 110.

In the semiconductor package 1000d according to an embodiment, the memory device 300 and the second semiconductor chip 160 may exchange a memory signal through the second redistribution substrate 130, the interposer chip 170, the rear wiring layer 127, the through-electrodes 129, the device layer 123, the through-electrodes 129, and the rear wiring layer 127. Referring to FIG. 9, a semiconductor package 1000e according to an embodiment may be substantially the same as the semiconductor package 1000d of FIG. 8A except that a lower package 100e may include an inter-substrate through-electrode 140c.

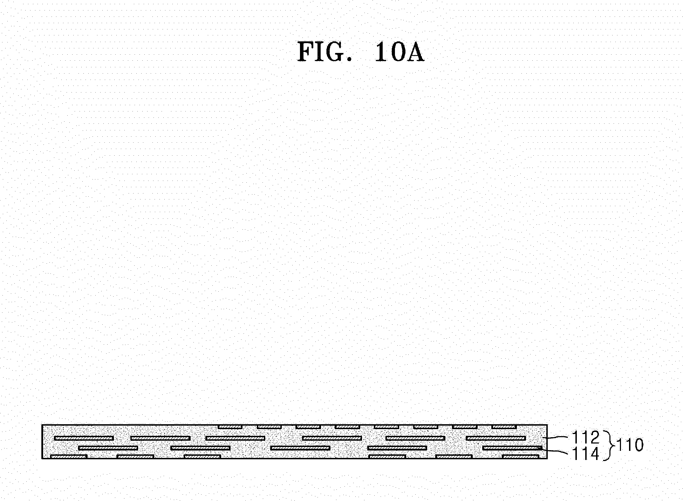

The inter-substrate through-electrode 140c may include an electrode metal layer 142 and a barrier metal layer 144. The inter-substrate through-electrodes 140c may be the same as the descriptions given with reference to the semiconductor package 1000a of FIG. 5. In the semiconductor package 1000e according to an embodiment, the inter-substrate through-electrodes 140c may have a structure passing through a thick sealant 150a surrounding a side surface of the stacked chip structure (refer to SC of FIG. 14A) instead of the first semiconductor chip 120, and thus, the size and pitch may be increased compared to the inter-substrate through-electrodes 140a of the semiconductor package 1000a of FIG. 5. FIGS. 10A to 10G are schematic cross-sectional views of stages in a method of manufacturing the semiconductor package 1000 of FIG. 1 according to an embodiment.

In the descriptions, FIG. 1 will also be referenced, and descriptions already given with reference to FIGS. 1 to 4C may be only briefly described or omitted. Referring to FIG. 10A, in the method of manufacturing the semiconductor package 1000 according to an embodiment, first, a first redistribution substrate 110 may be formed.

The first redistribution substrate 110 may include a first body insulating layer 112 and a first redistribution line 114. The first redistribution substrate 110 may be formed on a carrier substrate. The carrier substrate may be a large size substrate such as a wafer. In an implementation, the redistribution substrate formed on the carrier substrate may also be a large-size redistribution substrate including a plurality of first redistribution substrates 110. In an implementation, a semiconductor package that is individualized through a singulation process after subsequent components are formed on a large-size redistribution substrate may be referred to as a wafer level package (WLP).

For convenience of description, only one first redistribution substrate 110 and components corresponding thereto are illustrated in FIG. 10A and subsequent drawings. Thereafter, a seed metal may be formed on the first redistribution substrate 110.

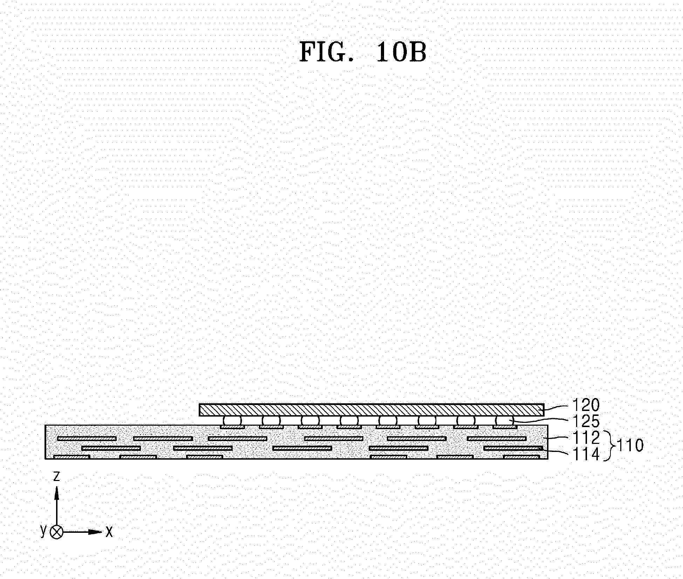

The seed metal may be used later when forming the inter-substrate through-electrodes 140 through electroplating. In the method of manufacturing a semiconductor package according to an embodiment, e.g., the seed metal may include Cu. Referring to FIG. 10B, afterwards, a first semiconductor chip 120 may be mounted on the first redistribution substrate 110.

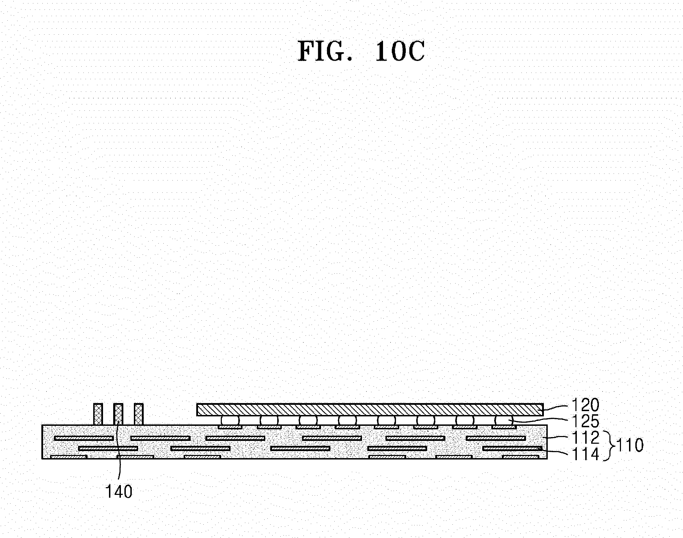

The first semiconductor chip 120 may be mounted on the first redistribution substrate 110 using the bumps 125 in a flip-chip bonding structure. In an implementation, as shown in FIG. 10B, the first semiconductor chip 120 may be biased to one side in the x direction, e.g., to the right. Referring to FIG. 10C, after mounting the first semiconductor chip 120 on the first redistribution substrate 110, inter-substrate through-electrodes 140 may be formed on the first redistribution substrate 110.

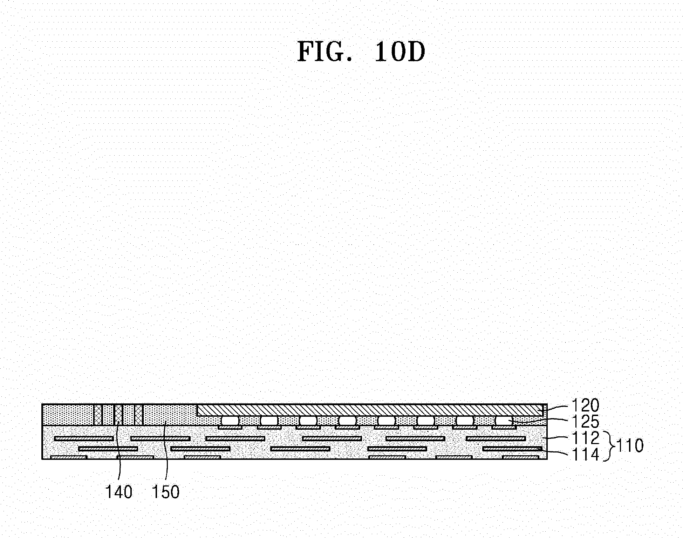

As described above, the inter-substrate through-electrodes 140 may be formed through electroplating. In an implementation, a photoresist (PR) may be coated on the first redistribution substrate 110, and a PR pattern exposing a seed metal on an upper surface of the first redistribution substrate 110 may be formed through an exposure process. Next, the inter-substrate through-electrodes 140 may be formed through electroplating using a seed metal. Thereafter, the PR pattern may be removed, and the seed metal exposed through the removal of the PR pattern may be removed. Referring to FIG. 10D, after forming the inter-substrate through-electrodes 140, a sealant 150 covering side surfaces of the first semiconductor chip 120 and the inter-substrate through-electrodes 140 may be formed.

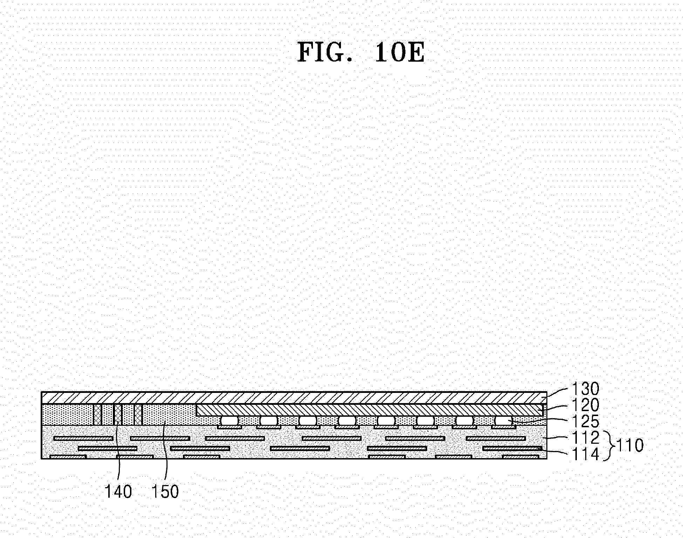

The sealant 150 may be first formed thick enough to cover upper surfaces of the first semiconductor chip 120 and the inter-substrate through-electrodes 140. Thereafter, an upper portion of the sealant 150 may be removed through a grinding process to expose the upper surfaces of the first semiconductor chip 120 and the inter-substrate through-electrodes 140, and thus, the sealant 150 may cover side surfaces of the first semiconductor chip 120 and the inter-substrate through-electrodes 140. As shown in FIG. 10D, the sealant 150 may fill between the first semiconductor chip 120 and the first redistribution substrate 110 and between the bumps 125. Referring to FIG. 10E, after the sealant 150 is formed, a second redistribution substrate 130 may be formed.

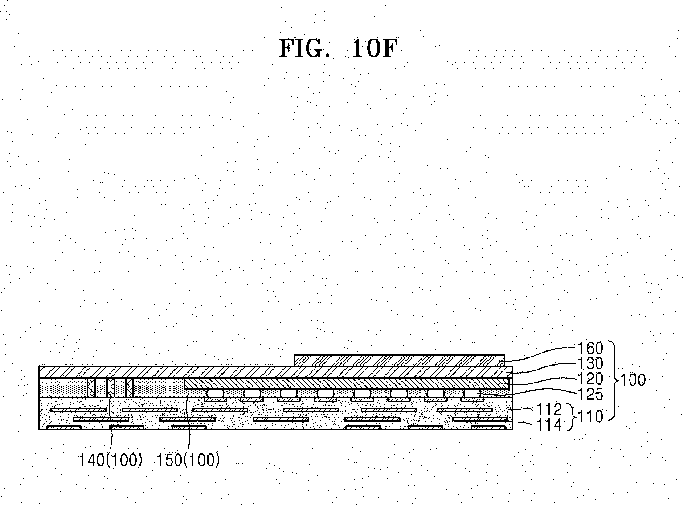

The second redistribution substrate 130 may be formed through substantially the same method as the first redistribution substrate 110. Accordingly, the second redistribution substrate 130 may include a body insulation layer and redistribution lines. The second redistribution substrate 130 may be formed so that substrate pads connected to the redistribution lines are connected to the inter-substrate through-electrodes 140, and also, connected to an upper pad of the rear wiring layer 127 of the first semiconductor chip 120. Referring to FIG. 10F, after forming the second redistribution substrate 130, a second semiconductor chip 160 may be mounted on the second redistribution substrate 130.

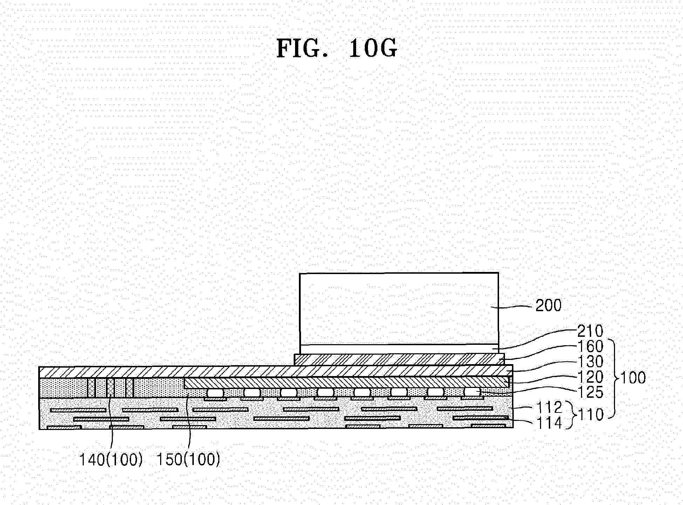

The second semiconductor chip 160 may be mounted on the second redistribution substrate 130 using, e.g., fine bumps. In an implementation, the second semiconductor chip 160 may be mounted on the second redistribution substrate 130 through bonding using HB or ACF. In an implementation, the second semiconductor chip 160 may be mounted on the second redistribution substrate 130 corresponding to the position of the first semiconductor chip 120 in order to minimize a signal transmission path length. In an implementation, the second semiconductor chip 160 may be biased to the right in the x direction and mounted on the second redistribution substrate 130. Referring to FIG. 10G, thereafter, a heat dissipation structure 200 may be stacked on the second semiconductor chip 160 and adhered thereto using an adhesive layer 210.

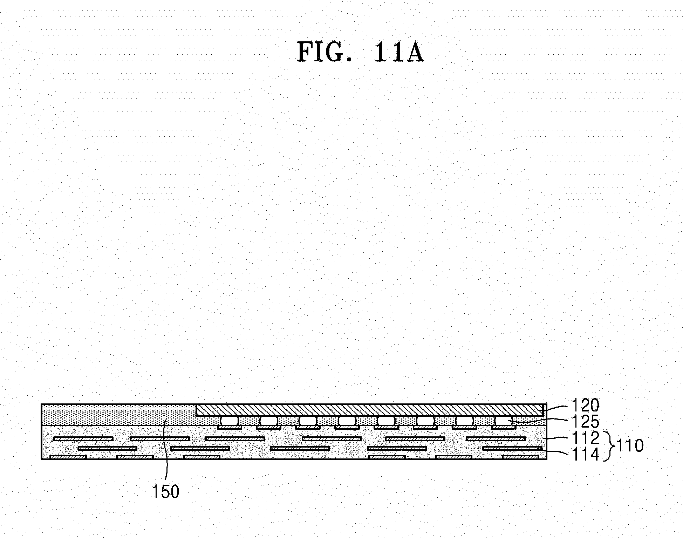

Next, a memory device 300 may be mounted on the second redistribution substrate 130 adjacent to the second semiconductor chip 160, and external connection terminals 400 and a passive device 500 may be on a lower surface of the first redistribution substrate 110. Thus, the manufacturing of the semiconductor package 1000 of FIG. 1 may be completed. For reference, the disposition of the external connection terminals 400 and the passive device 500 may be performed after separating the first redistribution substrate 110 from the carrier substrate. In addition, by individualizing a wafer-level package structure including a plurality of semiconductor packages through singulation, the semiconductor package 1000 of FIG. 1 may be substantially completed. The individualization process through singulation may be equally applied to the methods of manufacturing a semiconductor package according to other embodiments below. FIGS. 11A to 11D are schematic cross-sectional views of stages in a method of manufacturing the semiconductor package of FIG. 5 according to an embodiment.

In the descriptions, FIG. 5 will also be referenced, and descriptions already given with reference to FIG. 5 and FIGS. 10A to 10G may be only briefly described or omitted. Referring to FIG. 11A, in the method of manufacturing the semiconductor package1000a according to an embodiment, a first redistribution substrate 110 may be formed and a first semiconductor chip 120 may be mounted on the first redistribution substrate 110 through the processes of FIGS. 10A and 10B.

In an implementation, the inter-substrate through-electrodes 140a may be formed later through a laser drilling process, and a seed metal may not be formed on an upper surface of the first redistribution substrate 110. After the first semiconductor chip 120 is mounted, the sealant 150 covering side surfaces of the first semiconductor chip 120 may be formed.

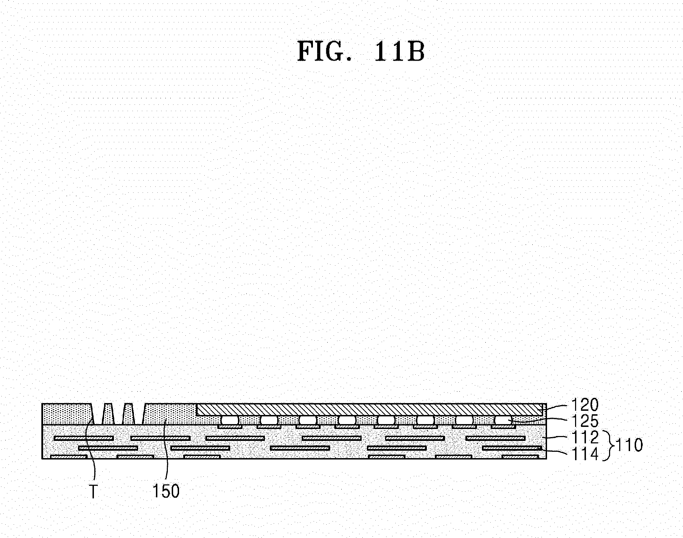

The sealant 150 may be initially formed thick enough to cover an upper surface of the first semiconductor chip 120. Thereafter, the upper surface of the first semiconductor chip 120 may be exposed by removing an upper portion thereof through a grinding process, and thus, the sealant 150 may cover the side surfaces of the first semiconductor chip 120. In addition, the sealant 150 may fill between the first semiconductor chip 120 and the first redistribution substrate 110 and between bumps 125. Referring to FIG. 11B, after the sealant 150 is formed, a plurality of trenches T may be formed in the sealant 150 through a laser drilling process.

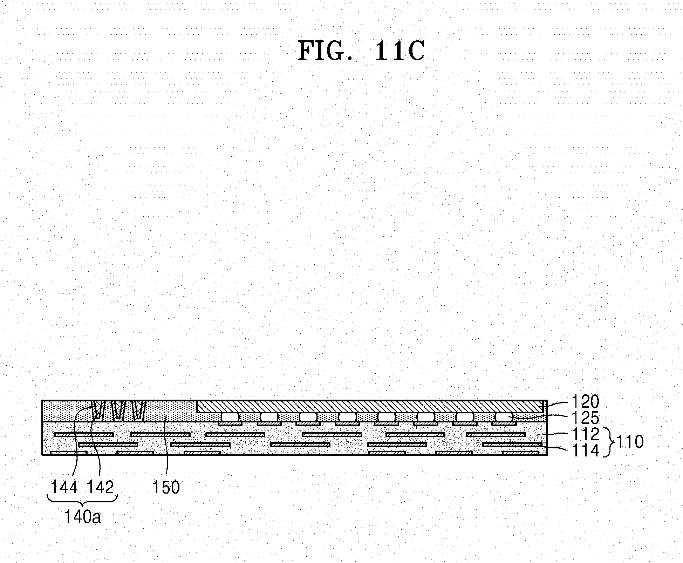

An upper surface of the first redistribution substrate 110 may be exposed through bottom surfaces of the trenches T. Referring to FIG. 11C, after forming the trenches T, the trenches T may be filled with a metal material to form inter-substrate through-electrodes 140a.

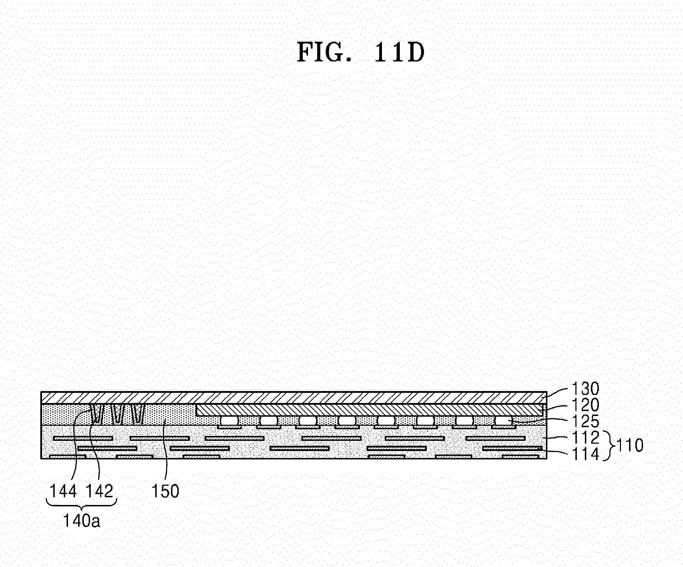

In an implementation, after a barrier metal material and an electrode metal material are sequentially deposited to fill the trenches T, the barrier metal material and electrode metal material on an upper surface of the sealant 150 and the first semiconductor chip 120 may be removed through a grinding process, and, as a result, the inter-substrate through-electrodes 140a having an electrode metal layer 142 and a barrier metal layer 144 may be formed in the trenches T. Referring to FIG. 11D, after forming the inter-substrate through-electrodes 140a, a second redistribution substrate 130 may be formed.

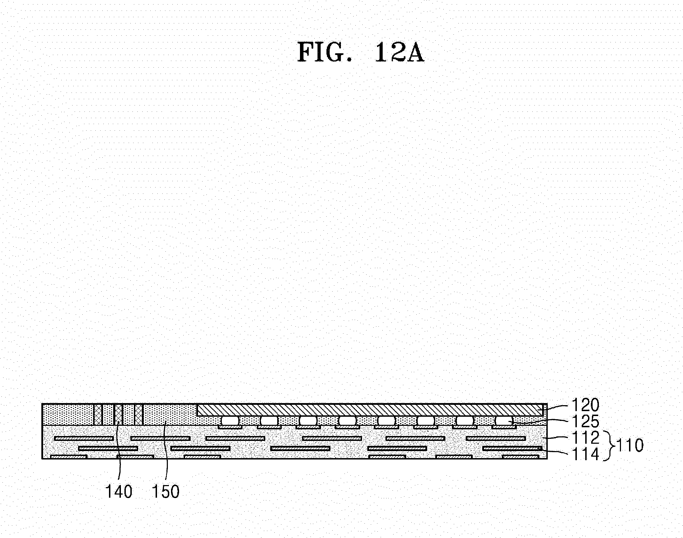

The second redistribution substrate 130 may be formed so that substrate pads connected to the redistribution line are connected to the inter-substrate through-electrodes 140a, and also connected to an upper pad of the rear wiring layer 127 of the first semiconductor chip 120. Subsequently, a second semiconductor chip 160 may be mounted on the second redistribution substrate 130, and a heat dissipation structure 200 may be stacked on the second semiconductor chip 160. In addition, a memory device 300 may be mounted on the second redistribution substrate 130 adjacent to the second semiconductor chip 160. Thereafter, by disposing external connection terminals 400 and a passive device 500 on a lower surface of the first redistribution substrate 110, the manufacture of the semiconductor package 1000a of FIG. 5 may be completed. FIGS. 12A to 12E are schematic cross-sectional views of stages in a method of manufacturing the semiconductor package 1000b of FIG. 6 according to an embodiment.

In the descriptions, FIG. 6 will also be referenced, and descriptions already given with reference to FIG. 6 and FIGS. 10A to 10G may be only briefly described or omitted. Referring to FIG. 12A, in the method of manufacturing the semiconductor package1000b according to an embodiment, a first redistribution substrate 110 may be formed, and a first semiconductor chip 120, inter-substrate through-electrodes 140, and a sealant 150 may be formed on the first redistribution substrate 110 through the processes of FIGS. 10A to 10D.

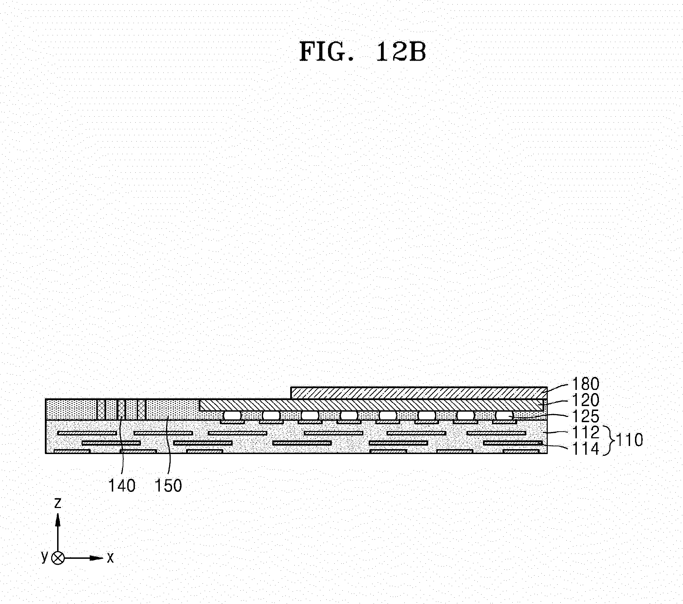

Referring to FIG. 12B, after forming the sealant 150, a film 180 may be attached to a portion of an upper surface of the first semiconductor chip 120.

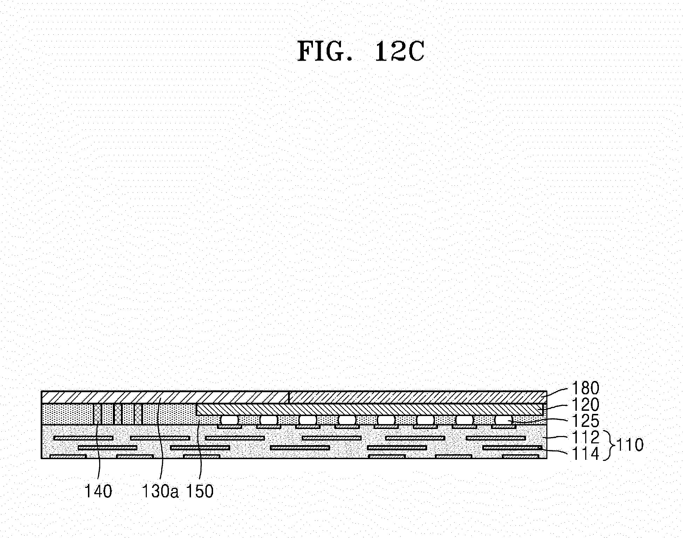

The film 180 may be attached on the upper surface of the first semiconductor chip 120 to secure a region for a second semiconductor chip 160 in a subsequent process. Accordingly, the film 180 may have a thickness similar to that of the second semiconductor chip 160. In an implementation, the second semiconductor chip 160 may be spaced apart from the second redistribution substrate 130a by a predetermined distance, and the film 180 may have a width in the x direction greater than that of the second semiconductor chip 160. The film 180 may be attached to the upper surface of the first semiconductor chip 120 using, e.g., an easily removable adhesive. Referring to FIG. 12C, after the film 180 is attached, a second redistribution substrate 130a may be formed.

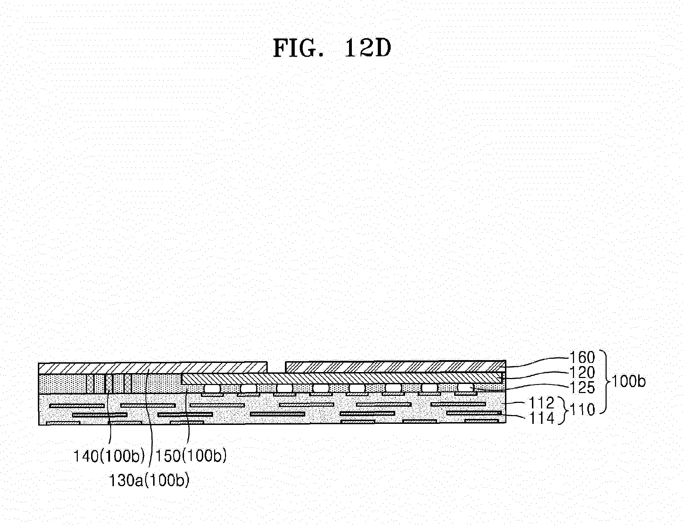

The second redistribution substrate 130a may be formed so that substrate pads connected to the redistribution line are connected to the inter-substrate through-electrodes 140, and also connected to an upper pad of the rear wiring layer 127 of the first semiconductor chip 120. In an implementation, the film 180 may be present on the upper surface of the first semiconductor chip 120, and the second redistribution substrate 130a may be formed only on a portion of the upper surface of the first semiconductor chip 120 where the film 180 is not present. Referring to FIG. 12D, after forming the second redistribution substrate 130a, the film 180 on the first semiconductor chip 120 may be removed.

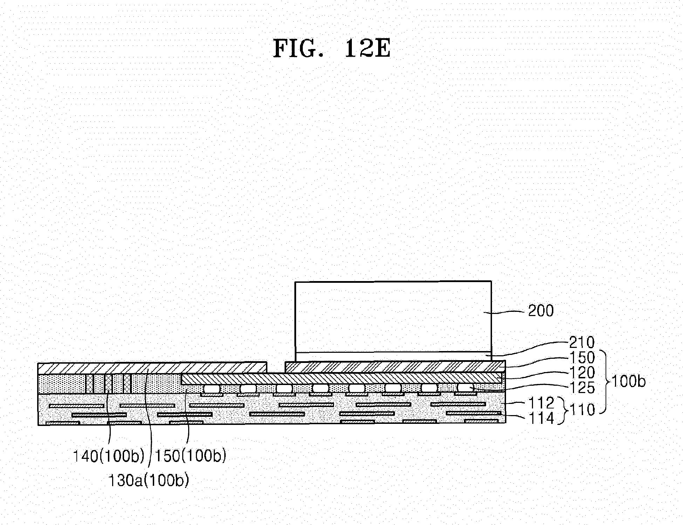

Thereafter, the second semiconductor chip 160 may be mounted on an upper surface of the first semiconductor chip 120 where the film 180 is removed. The second semiconductor chip 160 may be mounted on the first semiconductor chip 120 using, e.g., fine bumps. In an implementation, the second semiconductor chip 160 may be mounted on the first semiconductor chip 120 through bonding using HB or ACF. Referring to FIG. 12E, thereafter, a heat dissipation structure 200 may be stacked on the second semiconductor chip 160 and adhered thereto using an adhesive layer 210.

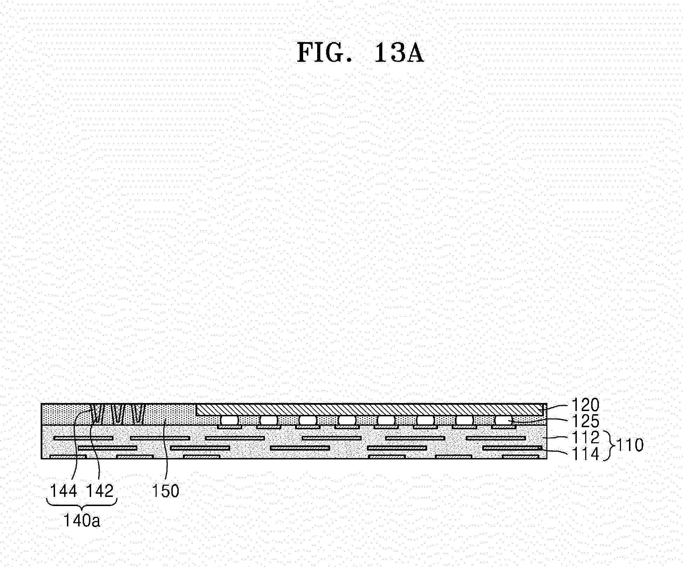

Thereafter, a memory device 300 may be mounted on the second redistribution substrate 130a adjacent to the heat dissipation structure 200. Subsequently, by disposing external connection terminals 400 and a passive device 500 on a lower surface of the first redistribution substrate 110, the manufacture of the semiconductor package 1000b of FIG. 6 may be completed. FIGS. 13A to 13C are schematic cross-sectional views of stages in a method of manufacturing the semiconductor package1000c of FIG. 7 according to an embodiment.

In the descriptions, FIG. 7 will also be referenced, and descriptions already given with reference to FIG. 7 and FIGS. 11A to 12E may be only briefly described or omitted. Referring to FIG. 13A, in the method of manufacturing the semiconductor package1000c according to an embodiment, a first redistribution substrate 110 may be formed and a first semiconductor chip 120 may be mounted on the first redistribution substrate 110 through the processes of FIGS. 10A and 10B.

In an implementation, a seed metal may not be formed on an upper surface of the first redistribution substrate 110. Afterwards, as shown in FIG. 11A, a sealant 150 covering a side surface of the first semiconductor chip 120 may be formed. After the sealant 150 is formed, a plurality of trenches may be formed in the sealant 150 through a laser drilling process.

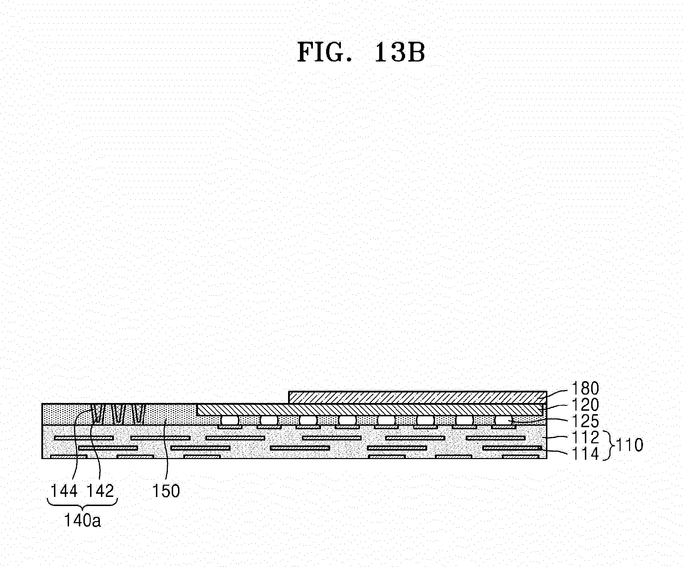

An upper surface of the first redistribution substrate 110 may be exposed through bottom surfaces of the trenches. After forming the trenches, inter-substrate through-electrodes 140a may be formed by filling the trenches with a metal material. The inter-substrate through-electrode 140a may include an electrode metal layer 142 and a barrier metal layer 144 in the trenches. The method of forming the inter-substrate through-electrodes 140a may be the same as described with reference to FIG. 11B. Referring to FIG. 13B, after forming the inter-substrate through-electrodes 140a, a film 180 may be attached to a portion of an upper surface of the first semiconductor chip 120.

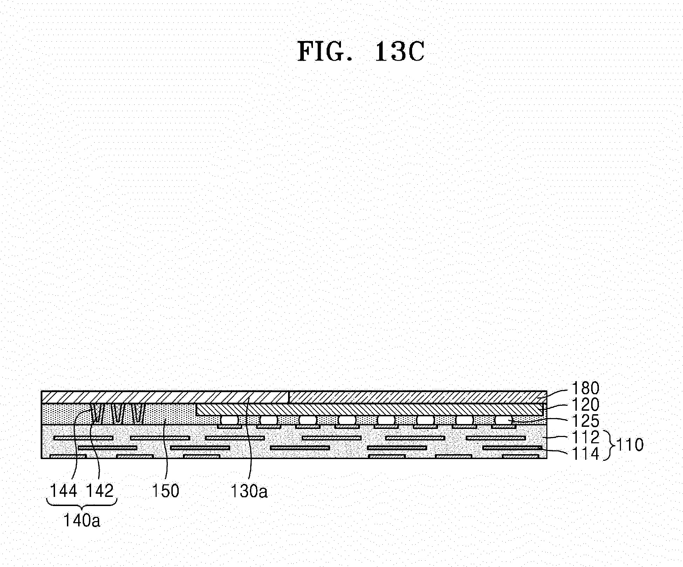

The size, the attachment method, and the attachment position of the film 180 may be the same as described with reference to FIG. 12B. Referring to FIG. 13C, after the film 180 is attached, a second redistribution substrate 130a may be formed.

The second redistribution substrate 130a may be formed so that substrate pads connected to the redistribution line are connected to the inter-substrate through-electrodes 140a and also connected to an upper pad of the rear wiring layer 127 of the first semiconductor chip 120. In an implementation, the second redistribution substrate 130a may be formed only on a portion of an upper surface of the first semiconductor chip 120 where the film 180 is not present. Subsequently, the semiconductor package 1000c of FIG. 7 may be completed through the processes of FIGS. 12D to 12E. FIGS. 14A to 14E are schematic cross-sectional views of stages in a method of manufacturing the semiconductor package 1000d of FIG. 8A according to an embodiment.

In the descriptions, FIGS. 8A and 8B will also be referenced, and descriptions already given with reference to FIGS. 8A and 8B and FIGS. 10A to 10G may be only briefly described or omitted. Referring to FIG. 14A, in the method of manufacturing the semiconductor package 1000d according to an embodiment, a second semiconductor chip 160 may be mounted on a first semiconductor chip 120.

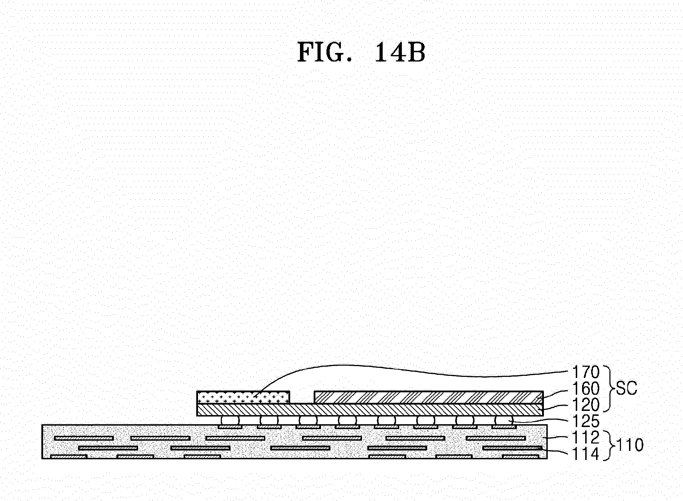

The second semiconductor chip 160 may be mounted on the first semiconductor chip 120 through, e.g., fine bumps. In an implementation, the second semiconductor chip 160 may be mounted on the first semiconductor chip 120 through bonding using HB or ACF. Thereafter, an interposer chip 170 may be mounted on the first semiconductor chip 120 adjacent to the second semiconductor chip 160. The interposer chip 170 may be mounted on the first semiconductor chip 120 through fine bumps. In an implementation, the interposer chip 170 may also be mounted on the first semiconductor chip 120 through bonding using HB or ACF. By mounting the second semiconductor chip 160 and the interposer chip 170 on the first semiconductor chip 120, a stacked chip structure SC may be formed. Referring to FIG. 14B, after forming the stacked chip structure SC, the stacked chip structure SC may be mounted on the first redistribution substrate 110.

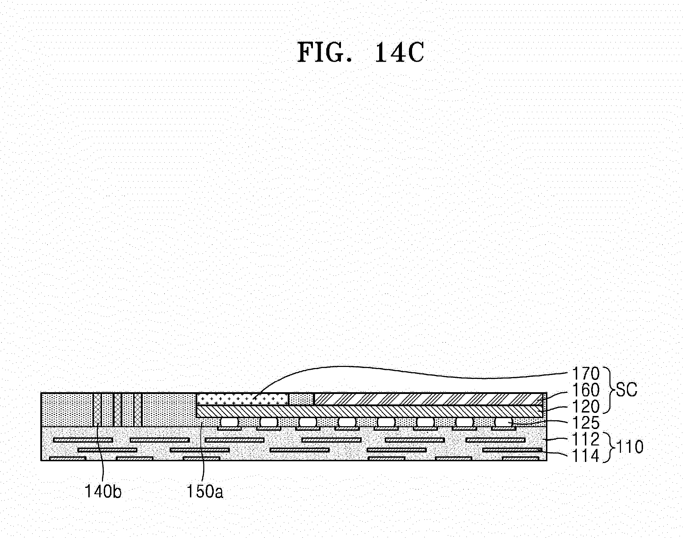

The first redistribution substrate 110 may be formed before or together with the formation of the stacked chip structure SC. In an implementation, the mounting of the stacked chip structure SC may be performed through a process of mounting the first semiconductor chip 120 on the first redistribution substrate 110 in a flip-chip bonding structure using bumps 125, and the method of mounting the stacked chip structure SC may be substantially the same as the method of mounting the first semiconductor chip 120 of FIG. 10B in terms of method. Referring to FIG. 14C, after the stacked chip structure SC is mounted, inter-substrate through-electrodes 140b and a sealant 150a may be formed through the processes described with reference to FIGS. 10C and 10D.

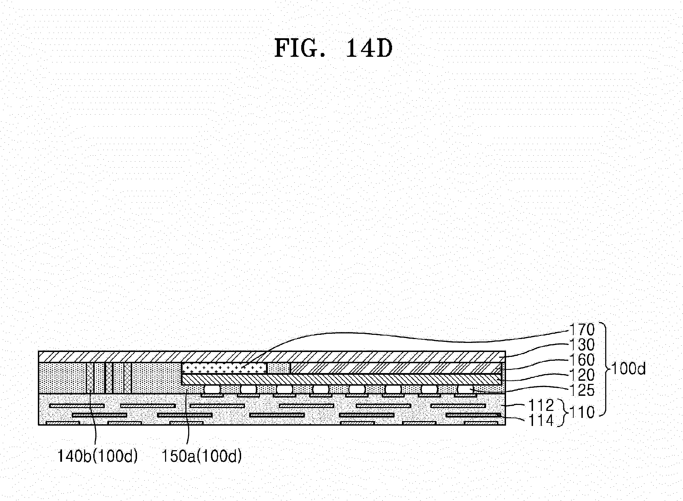

In an implementation, the stacked chip structure SC may be mounted on the first redistribution substrate 110, the size and pitch of the inter-substrate through-electrodes 140b may be increased, and the thickness of the sealant 150a may be increased. In an implementation, the sealant 150a may fill a gap between the second semiconductor chip 160 and the interposer chip 170 on the first semiconductor chip 120. Referring to FIG. 14D, after forming the sealant 150a, a second redistribution substrate 130 may be formed.

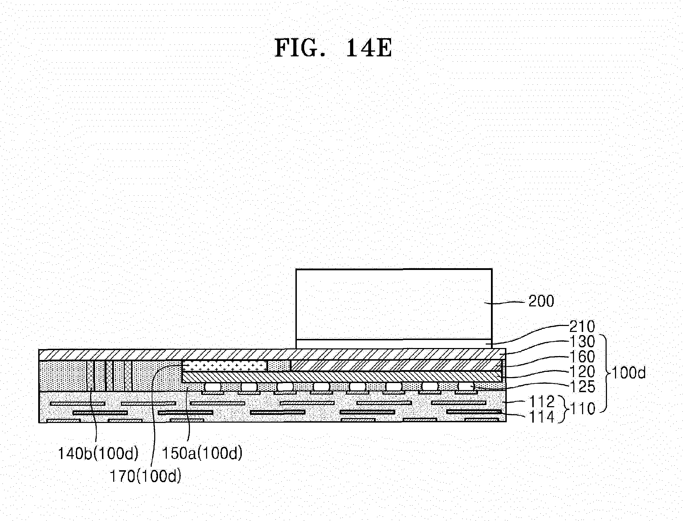

The second redistribution substrate 130 may be formed so that substrate pads connected to redistribution lines are connected to inter-substrate through-electrodes 140b, an upper pad of the rear wiring layer 127 of the first semiconductor chip 120, and an upper pad 178 of the interposer chip 170. Referring to FIG. 14E, after forming the second redistribution substrate 130, a heat dissipation structure 200 may be stacked on the second redistribution substrate 130 at a position corresponding to the second semiconductor chip 160 using an adhesive layer 210.

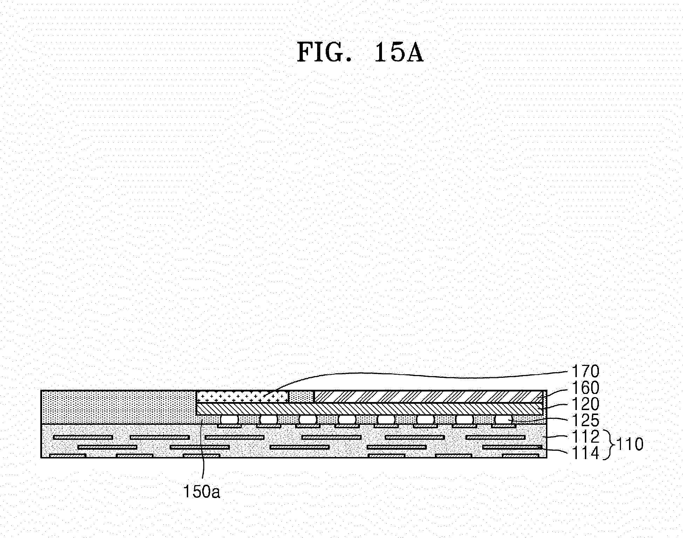

Subsequently, by mounting a memory device 300 on the second redistribution substrate 130 adjacent to the heat dissipation structure 200, and disposing external connection terminals 400 and a passive device 500 on a lower surface of the first redistribution substrate 110, the manufacture of the semiconductor package 1000d of FIG. 8A may be completed. FIGS. 15A to 15C are schematic cross-sectional views of stages in a method of manufacturing the semiconductor package 1000e of FIG. 9 according to an embodiment.

In the descriptions, FIG. 9 will also be referenced, and descriptions already given with reference to FIG. 9, FIGS. 11A to 11D, and FIGS. 14A to 14E may be only briefly described or omitted. Referring to FIG. 15A, in the method of manufacturing the semiconductor package 1000e according to an embodiment, a stacked chip structure SC may be mounted on a first redistribution substrate 110 through the processes described with reference to FIGS. 14A and 14B.

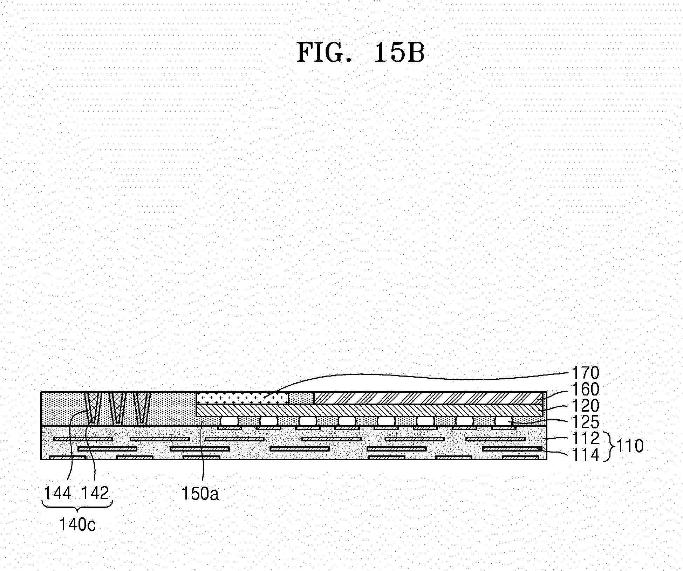

In an implementation, a seed metal may not be formed on an upper surface of the first redistribution substrate 110. After mounting the stacked chip structure SC, a sealant 150a covering a side surface of the stacked chip structure SC may be formed. The sealant 150a may fill a gap between the second semiconductor chip 160 and the interposer chip 170 on the first semiconductor chip 120. The sealant 150a may cover the side surface of the stacked chip structure SC, and the sealant 150a may have a thickness greater than that of the sealant 150 of the semiconductor package 1000 of FIG. 1. Referring to FIG. 15B, after the sealant 150a is formed, a plurality of trenches may be formed in the sealant 150a through a laser drilling process.

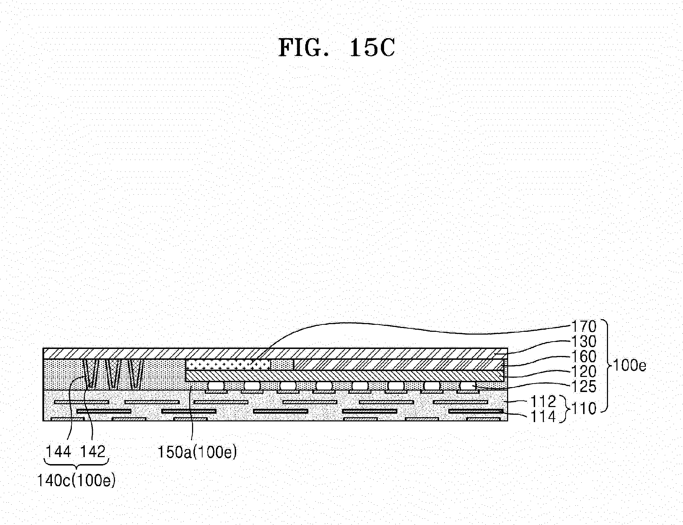

An upper surface of the first redistribution substrate 110 may be exposed through bottom surfaces of the trenches. After forming the trenches, the trenches may be filled with a metal material to form inter-substrate through-electrodes 140c. The inter-substrate through-electrode 140c may include an electrode metal layer 142 and a barrier metal layer 144 in the trenches. In an implementation, the sealant 150a may become thicker, the depth and width of the trenches may be increased, and accordingly, the size and pitch of the inter-substrate through-electrodes 140c may be increased. Referring to FIG. 15C, after forming the inter-substrate through-electrodes 140c, a second redistribution substrate 130 may be formed.

The second redistribution substrate 130 may be formed so that substrate pads connected to the redistribution lines are connected to the inter-substrate through-electrode 140c and an upper pad 178 of the interposer chip 170. Thereafter, a heat dissipation structure 200 may be stacked on the second redistribution substrate 130 at a position corresponding to the second semiconductor chip 160 and adhered thereto using an adhesive layer 210.

Subsequently, by mounting a memory device 300 on the second redistribution substrate 130 adjacent to the heat dissipation structure 200, and disposing external connection terminals 400 and a passive device 500 on a lower surface of the first redistribution substrate 110, the manufacture of the semiconductor package 1000e of FIG. 9 may be completed.

By way of summation and review, as semiconductor packages have high performance and high capacity, the power consumption thereof has increased. Accordingly, the heat dissipation characteristics of the semiconductor packages corresponding to the size/performance thereof has been considered.

One or more embodiments may provide a semiconductor package including redistribution substrates on top and bottom of a semiconductor chip.

One or more embodiments may provide a semiconductor package that minimizes a signal transmission path length between semiconductor chips in the semiconductor package and maximizes heat dissipation characteristics.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A semiconductor package, comprising:
a first redistribution substrate;
a first semiconductor chip on the first redistribution substrate;
a second redistribution substrate on the first semiconductor chip;
inter-substrate through-electrodes on the first redistribution substrate at one side of the first semiconductor chip and connecting the first redistribution substrate to the second redistribution substrate;
a second semiconductor chip on the first semiconductor chip; and
a heat dissipation structure on the second semiconductor chip.

2. The semiconductor package as claimed in claim 1, wherein:
the second redistribution substrate covers an entire upper surface of the first semiconductor chip; and
the second semiconductor chip is on the second redistribution substrate.

3. The semiconductor package as claimed in claim 2, further comprising a memory device on the second redistribution substrate at one side of the second semiconductor chip,
wherein the memory device and the second semiconductor chip are configured to exchange memory signals without the memory signals passing through the first redistribution substrate.

4. The semiconductor package as claimed in claim 3, wherein the memory device has a package structure including a plurality of memory chips.

5. The semiconductor package as claimed in claim 3 or 4, wherein:
the first semiconductor chip is mounted on the first redistribution substrate via a flip-chip structure including bumps,
the first semiconductor chip includes a substrate, a device layer under the substrate, a rear wiring layer above the substrate, and a through-electrode penetrating the substrate to connect the rear wiring layer to the device layer, and
the memory device and the second semiconductor chip are configured to exchange a memory signal via the second redistribution substrate, the rear wiring layer, a first through-electrode, the device layer, the first through-electrode, the rear wiring layer, and the second redistribution substrate.

6. The semiconductor package as claimed in claim 1, wherein:
the second redistribution substrate covers a portion of the upper surface of the first semiconductor chip; and
the second semiconductor chip is on the first semiconductor chip and adjacent to one side surface of the second redistribution substrate.

7. The semiconductor package as claimed in claim 6, further comprising a memory device on the second redistribution substrate,
wherein the memory device and the second semiconductor chip are configured to exchange memory signals without the memory signals passing through the first redistribution substrate.

8. The semiconductor package as claimed in claim 7, wherein:
the first semiconductor chip is mounted on the first redistribution substrate via a flip-chip structure including bumps,
the first semiconductor chip includes a substrate, a device layer under the substrate, a rear wiring layer above the substrate, and a through-electrode penetrating the substrate to connect the rear wiring layer and the device layer, and
the memory device and the second semiconductor chip are configured to exchange the memory signals via the second redistribution substrate, the rear wiring layer, a first through-electrode, the device layer, the first through-electrode, and the rear wiring layer.

9. The semiconductor package as claimed in any preceding claim, further comprising a sealant between the first redistribution substrate and the second redistribution substrate,
wherein:
the inter-substrate through-electrodes penetrate the sealant, and
the sealant is not included between the first semiconductor chip and the second redistribution substrate.

10. The semiconductor package as claimed in any preceding claim, further comprising a passive device on a lower surface of the first redistribution substrate.

11. The semiconductor package as claimed in claim 1, further comprising an interposer chip on the first semiconductor chip on one side of the second semiconductor chip,
wherein:
the second semiconductor chip is on the first semiconductor chip, and
the second redistribution substrate covers the second semiconductor chip and the interposer chip.

12. A method of manufacturing a semiconductor package, the method comprising:
preparing a first redistribution substrate;
mounting a first semiconductor chip on the first redistribution substrate;
forming inter-substrate through-electrodes on the first redistribution substrate on one side of the first semiconductor chip;
sealing the inter-substrate through-electrodes and the first semiconductor chip with a sealant;
forming a second redistribution substrate on the first semiconductor chip, the inter-substrate through-electrodes, and the sealant; and
mounting a second semiconductor chip on the first semiconductor chip or the second redistribution substrate.

13. The method as claimed in claim 12, further comprising:
stacking a heat dissipation structure on the second semiconductor chip after mounting the second semiconductor chip; and
mounting a memory device on the second redistribution substrate on one side of the second semiconductor chip,
wherein:
forming the second redistribution substrate includes forming the second redistribution substrate to cover an entire upper surface of the first semiconductor chip, and
mounting the second semiconductor chip includes mounting the second semiconductor chip on a portion of the second redistribution substrate corresponding to the first semiconductor chip.

14. The method as claimed in claim 12, further comprising:
attaching a film to a portion of the first semiconductor chip corresponding to the second semiconductor chip before forming the second redistribution substrate;
stacking a heat dissipation structure on the second semiconductor chip after mounting the second semiconductor chip; and
mounting a memory device on the second redistribution substrate,
wherein:
sealing the inter-substrate through-electrodes and the first semiconductor chip with the sealant includes exposing upper surfaces of the inter-substrate through-electrodes and an upper surface of the first semiconductor chip through the sealant,
forming the second redistribution substrate includes forming the second redistribution substrate so as to cover a portion of an upper surface of the first semiconductor chip excluding the film, and
mounting the second semiconductor chip includes removing the film and mounting a second semiconductor chip on the first semiconductor chip.

15. The method as claimed in any one of claims 12 to 14, wherein the inter-substrate through-electrodes are formed using:
a photoresist pattern and a plating process, or
a laser drilling and a deposition process.
